# EUROPÄISCHE PATENTSCHRIFT

(11) **EP 3 599 647 B1**
(45) Veröffentlichungstag und Bekanntmachung des Hinweises auf die Patenterteilung: **08.09.2021**
(21) Anmeldenummer: 18186153.5
(22) Anmeldetag: 27.07.2018
(51) Int. Cl.: H01L 31/0236, H01L 31/048, H01L 31/054, H02S 20/22

(54) **SOLARMODUL MIT STRUKTURIERTER DECKPLATTE UND OPTISCHER INTERFERENZSCHICHT**
SOLAR MODULE WITH STRUCTURED COVER PLATE AND OPTICAL INTERFERENCE LAYER
MODULE SOLAIRE POURVU DE PLAQUE DE COUVERTURE STRUCTURÉE ET DE COUCHE D'INTERFÉRENCE OPTIQUE

(43) Veröffentlichungstag der Anmeldung: 29.01.2020
(73) Patentinhaber: (CNBM) Bengbu Design & Research Institute for Glass Industry Co., Ltd., 233010 Bengbu (CN)
(72) Erfinder: KALIO, René, 04357 Leipzig (DE); PALM, Jörg, 80797 München (DE); KULLMANN, Jens, 06917 Jessen (DE); DIAS, Manuel, 65183 Wiesbaden (DE); RING, Sven, 10247 Berlin (DE)
(74) Vertreter: Evans, Huw David Duncan

(56) Entgegenhaltungen:
- WO-A1-2009/062106
- WO-A1-2013/056747
- WO-A1-2015/151819
- DE-A1-102007 054 124
- US-A1- 2009 095 341

## Beschreibung

Die vorliegende Erfindung liegt auf dem technischen Gebiet der fotovoltaischen Energieerzeugung und betrifft ein Solarmodul mit einer strukturierten Deckplatte und mindestens einer optischen Interferenzschicht. Die Erfindung erstreckt sich weiterhin auf ein Verfahren zur Herstellung des erfindungsgemäßen Solarmoduls sowie dessen Verwendung.

Die Verwendung von Solarmodulen als Wand- bzw. Fassadenelemente ist derzeit ein wirtschaftlich noch relativ geringer, jedoch ökologisch sehr interessanter Markt. Insbesondere angesichts verstärkter Bemühungen für dezentrale Energielösungen und energie-neutrale Gebäude wächst der Bedarf für die Anwendung von Solarmodulen als integrierte Bestandteile von Gebäudehüllen. Weitere interessante Anwendungsbereiche für Solarmodule sind Lärmschutzwände (Straße, Schiene), Sichtschutzwände im Außenbereich oder Wände für Gewächshäuser. Diese neuen Anwendungen stellen völlig neue Anforderungen an Solarmodule, insbesondere im Hinblick auf Ästhetik, Lebensdauer und weitere Funktionalitäten wie Abdichtung und Wärmeisolation. Insbesondere müssen die hierfür eingesetzten Solarmodule in verschiedenen Formen, Größen und Farben zur Verfügung stehen und einen möglichst homogenen Farbeindruck vermitteln. Je nach Ursprung der Farbe (Absorption/Remission, Interferenz, Brechung) kann die Farbe einer an sich homogenen Oberfläche des Solarmoduls vom Betrachtungs- und/oder Einstrahlwinkel abhängen. Darüber hinaus bestimmen auch das Spektrum und die räumliche Verteilung (diffus, gerichtet) des Lichtes den Farbeindruck.

Diese neuen Anwendungen stellen völlig neue Anforderungen an Solarmodule, insbesondere im Hinblick auf Ästhetik, Lebensdauer und weitere Funktionalitäten wie Abdichtung und Wärmeisolation. Insbesondere müssen die hierfür eingesetzten Solarmodule in verschiedenen Formen, Größen und Farben zur Verfügung stehen und einen möglichst homogenen Farbeindruck vermitteln. Diese Anforderungen an die Solarmodule bereiten jedoch technische Probleme, die mit der eigentlichen Funktionalität der Solarmodule, nämlich einer möglichst effizienten Generation von elektrischer Leistung aus Sonnenlicht, in Konflikt stehen.

Ein ideales Solarmodul wäre hinsichtlich Wirkungsgradoptimierung ein schwarzer Körper, der das auftreffende Licht vollständig absorbiert, um die Strahlungsenergie optimal in elektrische Energie umzuwandeln. Jedoch wird von jedem realen Körper auftreffende Strahlung reflektiert und absorbierte Strahlung remittiert, wobei der Farbeindruck im menschlichen Auge grundsätzlich aus der spektral selektierten Reflexion und der Remission von Licht entsteht. Das Sonnenspektrum hat im sichtbaren Spektralbereich die höchste Energieintensität und das menschliche Auge die größte Empfindlichkeit. Wird ein Solarmodul farbig gestaltet, d.h. soll im menschlichen Auge ein Farbeindruck des Solarmoduls erzeugt werden, der vom idealen schwarzen Körper verschieden ist, reduziert man zwingend die Intensität des im fotovoltisch aktiven Halbleiter absorbierten Lichts und damit auch die elektrische Leistung bzw. den Wirkungsgrad des Solarmoduls. Ein optimaler Wirkungsgrad kann grundsätzlich nur mit einem schwarzen Solarmodul erzielt werden. Andererseits kann, je nach Ursprung der Farbe (Absorption/Remission, Interferenz, Brechung), die Farbe einer an sich homogenen Oberfläche des Solarmoduls vom Betrachtungs- und/oder Einstrahlwinkel abhängen. Darüber hinaus bestimmen auch das Spektrum und die räumliche Verteilung (diffus, gerichtet) des Lichtes den Farbeindruck.

In der internationalen Patentanmeldung WO 2014/045142 sind Vielfach-Interferenzschichten auf der Innenseite eines Frontglases beschrieben, die einen definierten Spektralbereich des Sonnenlichts reflektieren. Derartige Vielfach-Interferenzschichten sind in der Herstellung sehr teuer und eignen sich deshalb nur bedingt für die industrielle Verwertung. Gezeigt ist auch die optionale Verwendung von diffus streuendem Deckglas, wobei sich die Vielfach-Interferenzschicht und die aufgeraute Seite des Deckglases auf verschiedenen Seiten des Deckglases befinden (Vielfach-Interferenzschicht innen, Aufrauung außen). Ein Solarmodul mit einer strukturierten Deckplatte und einer Interferenzschicht ist aus der Patentanmeldung WO 2015/151819 A1 bekannt.

Bekannt ist auch die Verwendung von bionischen Verfahren, bei denen Nanostrukturen erzeugt werden, die denen von Schmetterlingen gleichen (siehe Fraunhofer, Bläsi et al. 33rd European PV Solar Energy Conference and Exhibition, 24-29 September 2017, Amsterdam, The Netherlands*).* Diese Verfahren sind sehr aufwändig und kostenintensiv und eignen sich noch nicht für die industrielle Serienfertigung von großflächigen Solarmodulen.

Bekannt ist ferner das Aufbringen von Farben auf Deckgläser durch keramischen Siebdruck oder die Verwendung von organischen Glasfarben. Dies sind vergleichsweise preiswerte Technologien, die auch ein breites Spektrum von Farben erzeugen können. Zudem ist der Farbeindruck nur wenig winkelabhängig. Jedoch sind Farbschichten als solche grundsätzlich opak und lichtabsorbierend, so dass der Wirkungsgradverlust zwangsläufig sehr hoch ist. Dies gilt insbesondere für helle Farbtöne, die in aller Regel zu einem inakzeptablen Wirkungsgradverlust führen.

Demgegenüber besteht die Aufgabe der vorliegenden Erfindung darin, ein farbiges Solarmodul zur Verfügung zu stellen, wobei die Farbe möglichst wenig vom Betrachtungs- und Einstrahlwinkel abhängen soll, da ansonsten bei der Verwendung im gebäudeintegrierten Umfeld die Farbe stark vom Ort des Betrachters bzw. Sonnenstand abhängen würde. Für jede vom Kunden gewünschte Farbe sollte zudem der Wirkungsgradverlust des Solarmoduls möglichst gering sein. Für eine industrielle Serienfertigung ist es zudem wichtig, dass die Solarmodule auf großen Flächen, sowie zu akzeptablen Kosten und mit zufriedenstellender Homogenität herstellbar sind.

Diese und weitere Aufgaben werden nach dem Vorschlag der Erfindung durch ein Solarmodul und ein Verfahren zu dessen Herstellung gemäß den nebengeordneten Patentansprüchen gelöst. Vorteilhafte Ausgestaltungen der Erfindung sind durch die Merkmale der Unteransprüche angegeben.

Erfindungsgemäß ist ein Solarmodul mit elektrisch in Serie verschalteten Solarzellen zur fotovoltaischen Energieerzeugung gezeigt. Grundsätzlich kann es sich bei dem erfindungsgemäßen Solarmodul um jede Art von Solarmodul handeln, insbesondere um ein Silizium-basiertes Solarmodul auf Wafer-Basis oder ein Dünnschichtsolarmodul mit in monolithisch integrierter Form serienverschalteten Solarzellen.

Vorzugsweise ist das erfindungsgemäße Solarmodul ein Dünnschichtsolarmodul. Vorteilhaft handelt es sich bei dem Solarmodul um ein Dünnschichtsolarmodul mit Verbundscheibenstruktur, welches über eine frontseitige transparente Deckplatte und ein rückseitiges Substrat (z.B. Glasplatten) verfügt, die durch eine thermoplastische oder vernetzende Polymer-Zwischenschicht (z.B. PVB oder EVA) fest miteinander verbunden sind. Die Erfindung bezieht sich insbesondere auf ein Dünnschichtsolarmodul in Substratkonfiguration, bei der der Schichtenaufbau zur Herstellung der Solarzellen auf einer der Lichteintrittsseite zugewandten Oberfläche des rückseitigen Substrats aufgebracht ist. Die Erfindung bezieht sich gleichermaßen auf ein Dünnschichtsolarmodul in Superstratkonfiguration, bei welcher der Schichtenaufbau auf einer von der Lichteintrittsseite abgewandten Oberfläche der frontseitigen transparenten Deckplatte aufgebracht ist.

In Einklang mit der üblichen Verwendung bezieht sich der Begriff "Dünnschichtsolarmodul" auf Module mit einem Schichtenaufbau mit einer geringen Dicke von beispielsweise einigen Mikrometern, welche einen Träger für eine ausreichende mechanische Festigkeit benötigen. Der Träger kann beispielsweise aus anorganischem Glas, Kunststoff, Metall oder einer Metallegierung bestehen und kann in Abhängigkeit von der jeweiligen Schichtdicke und den spezifischen Materialeigenschaften als starre Platte oder biegsame Folie ausgestaltet sein.

Bei einem Dünnschichtsolarmodul umfasst der Schichtenaufbau in an sich bekannter Weise eine Rückelektrodenschicht, eine Frontelektrodenschicht, und eine zwischen Rück- und Frontelektrodenschicht angeordnete, fotovoltaisch aktive Absorberschicht. Die Frontelektrodenschicht ist optisch transparent, da ein Durchtritt von Licht zum Schichtenaufbau ermöglicht sein muss. Die optisch transparente Frontelektrodenschicht umfasst oder besteht typischer Weise aus einem dotierten Metalloxid (TCO = Transparent Conductive Oxide), beispielsweise n-leitendes, insbesondere Aluminiumdotiertes, Zinkoxid (AZO).

Vorzugsweise umfasst oder besteht die fotovoltaisch aktive Absorberschicht aus einem Chalkopyrit-Halbleiter, bei dem es sich vorteilhaft um einen ternären I-III-VI-Verbindungshalbleiter aus der Gruppe Kupfer-Indium/Gallium-Disulfid/Diselenid (Cu(In,Ga)(S,Se)₂) handelt. In vorstehender Formel können Indium und Gallium jeweils allein oder in Kombination vorliegen. Entsprechendes gilt für Schwefel und Selen, die jeweils allein oder in Kombination vorliegen können. Als Material für die Absorberschicht eignet sich in besonderer Weise CIS (Kupferindiumdiselenid/-disulfid) oder CIGS (Kupferindiumgalliumdiselenid, Kupferindiumgalliumdisulfid, Kupferindiumgalliumdisulfoselenid). Die Absorberschicht weist typischer Weise eine Dotierung von einem ersten Leitungstyp (Ladungsträgertyp) und die Frontelektrode eine Dotierung vom entgegengesetzten Leitungstyp auf. In aller Regel ist die Absorberschicht p-leitend (p-dotiert), verfügt also über einen Überschuss von Defektelektronen (Löcher), und die Frontelektrodenschicht ist n-leitend (n-dotiert), so dass freie Elektronen in Überschuß vorhanden sind. Zwischen Absorberschicht und Frontelektrodenschicht ist typischer Weise eine Pufferschicht angeordnet. Dies gilt insbesondere für Absorberschichten auf Basis von Cu(In,Ga)(S,Se)₂, bei denen in aller Regel eine Pufferschicht zwischen einer p-leitenden Cu(In,Ga)(S,Se)₂-Absorberschicht und einer n-leitenden Frontelektrode benötigt wird. Nach derzeitiger Erkenntnis ermöglicht die Pufferschicht eine elektronische Anpassung zwischen Absorber und Frontelektrode. Sie bietet außerdem einen Schutz vor Sputterschäden in einem nachfolgenden Prozeßschritt der Abscheidung der Frontelektrode beispielsweise durch DC-Magnetron-Sputtern. Durch die Abfolge aus n-leitender Frontelektrodenschicht, Pufferschicht und p-leitender Absorberschicht wird ein p-n-Heteroübergang gebildet, das heißt ein Übergang zwischen Schichten vom entgegengesetzten Leitungstyp. Die fotovoltaisch aktive Absorberschicht kann beispielsweise auch aus Cadmiumtellerid (CdTe) oder amorphem und/oder mikrokristallinem Silizium bestehen.

Im Dünnschichtsolarmodul sind durch Strukturierungszonen serienverschaltete Solarzellen ausgebildet. So ist mindestens die Rückelektrodenschicht durch erste Strukturierungslinien (P1-Linien) in vollständig voneinander getrennte Abschnitte unterteilt, welche die Rückelektroden der Solarzellen bilden. Ferner ist mindestens die Absorberschicht durch zweite Strukturierungslinien (P2-Linien) in vollständig voneinander getrennte Abschnitte unterteilt, welche die Absorber der Solarzellen bilden, und mindestens die Frontelektrodenschicht ist durch dritte Strukturierungslinien (P3-Linien) in vollständig voneinander getrennte Abschnitte unterteilt, welche die Frontelektroden der Solarzellen bilden. Benachbarte Solarzellen sind über elektrisch leitfähiges Material in den zweiten Strukturierungslinien in Serienverschaltung elektrisch miteinander verbunden, wobei die Frontelektrode einer Solarzelle mit der Rückelektrode der benachbarten Solarzelle elektrisch verbunden ist und mit dieser typischer Weise, jedoch nicht zwingend, direkten Berührungskontakt hat. Jede Strukturierungszone umfasst eine unmittelbare Abfolge der drei Strukturierungslinien P1-P2-P3, jeweils in dieser Reihenfolge.

In Einklang mit der gängigen Verwendung bezieht sich der Begriff "Solarzelle" auf einen Bereich des Schichtenaufbaus, der eine Frontelektrode, einen fotovoltaisch aktiven Absorber und eine Rückelektrode aufweist und von zwei einander unmittelbar benachbarten Strukturierungszonen begrenzt wird. Im Randbereich des Moduls gilt dies analog, wobei anstelle einer Strukturierungszone ein Anschlussabschnitt für eine elektrische Kontaktierung der Serienverschaltung der Solarzellen vorhanden ist, so dass die Solarzelle durch den Schichtenbereich mit Frontelektrode, Absorber und Rückelektrode definiert ist, der sich zwischen einer Strukturierungszone und dem unmittelbar angrenzenden Anschlussabschnitt befindet. Jede Solarzelle weist eine optisch aktive Zone auf, die, stapelförmig übereinander angeordnet, eine Rückelektrode, einen Absorber und eine Frontelektrode umfasst und zur fotoelektrischen Konversion von Licht in elektrischen Strom fähig ist.

Das erfindungsgemäße Solarmodul umfasst eine lichteintritts- bzw. frontseitige transparente Deckplatte, die eine der äußeren Umgebung zugewandte Außenfläche und gegenüberliegend zur Außenfläche eine Innenfläche aufweist. Die Außenfläche der Deckplatte ist im verbauten Zustand des Fassadenelements in der Fassade der äußeren Umgebung zugewandt und bildet, gegebenenfalls mit hierauf aufgebrachten Schichten, einen Teil der Außenseite bzw. Außenfläche der Fassade. Gemäß einer Ausgestaltung der Erfindung besteht die Deckplatte aus einem selben Material, beispielsweise Glas oder Kunststoff, vorzugsweise Kalknatronglas. Vorzugsweise ist die Deckplatte eine starre Glas- oder Kunststoffplatte. Die Außenfläche bzw. Innenfläche der Deckplatte wird in diesem Fall vom jeweiligen Material der Deckplatte gebildet. Gemäß einer alternativen Ausgestaltung der Erfindung besteht die Deckplatte aus mindestens zwei verschiedenen Materialien, wobei die Außenfläche und/oder Innenfläche der Deckplatte aus einem von einem Kern der Deckplatte verschiedenen Material gebildet wird. Der Kern der Deckplatte besteht vorzugsweise aus einem gleichen Material, beispielsweise Glas oder Kunststoff, vorzugsweise Kalknatronglas. Auf den Kern der Deckplatte ist außen- und/oder innenseitig ein vom Kern der Deckplatte verschiedenes Material angebracht, welches transparent ist und einen selben optischen Brechungsindex wie das Material des Kerns der Deckplatte hat. Die Außenfläche bzw. Innenfläche der Deckplatte wird in diesem Fall vom jeweiligen Material gebildet, das auf den Kern der Deckplatte aufgebracht ist. Erfindungsgemäß umfasst der Begriff "Deckplatte" somit auch Verbundkörper, mit der Maßgabe, dass die Materialien, welche die Deckplatte formen, transparent sind und einen gleichen optischen Brechungsindex haben. Vorzugsweise weist die Deckplatte keine Krümmung auf und ist somit plan (eben). Die Deckplatte kann jedoch auch gekrümmt sein. Die Deckplatte kann starr oder biegsam sein. In Form einer biegsamen Deckplatte kann sie in ebener Form bereitgestellt werden.

Eine ebene (plane) Deckplatte definiert eine Ebene, welche im Sinne vorliegender Erfindung als "Ebene der Deckplatte" zu verstehen ist. Bei einer gekrümmten Deckplatte kann durch eine (gedachte) ebene Tangentialfläche an einem beliebigen Punkt der Ebene, eine lokale Ebene definiert werden, welche ebenfalls als "Ebene der Deckplatte" zu verstehen ist.

Im Sinne vorliegender Erfindung bezieht sich der Begriff "Transparenz" bzw. "transparent" auf eine Durchlässigkeit für sichtbares Licht von wenigstens 85%, insbesondere wenigstens 90%, vorzugsweise wenigstens 95%, insbesondere 100%. Typischer Weise liegt sichtbares Licht im Wellenlängenbereich von 380 nm bis 780 nm vor. Der Begriff "Opazität" bzw. "opak" bezieht sich auf eine Durchlässigkeit für sichtbares Licht von weniger als 5%, insbesondere 0%. Die prozentualen Angaben beziehen sich auf die Intensität des Lichts, gemessen modulinnenseitig der frontseitigen Deckplatte, bezogen auf die Intensität des auf die frontseitige Deckplatte von der äußeren Umgebung her auftreffenden Lichts. Die Transparenz des Deckplatte kann in einfacher Weise durch eine Meßanordnung bestimmt werden, bei der beispielsweise eine Weißlichtquelle (Quelle für sichtbares Licht) auf einer Seite der frontseitigen Deckplatte und ein Detektor für sichtbares Licht auf der anderen Seite der frontseitigen Deckplatte angeordnet werden. Die nachfolgend genannten Werte für den optischen Brechungsindex beziehen sich immer auf den optischen Brechungsindex im sichtbaren Wellenlängenbereich von 380 nm bis 780 nm.

Das erfindungsgemäße Solarmodul vermittelt dem Betrachter bei Beleuchtung der Modulaußenseite mit weißem Licht, insbesondere bei Beleuchtung mit Sonnenlicht, in mindestens einem Modulabschnitt einen homogenen Farbeindruck, d.h. das Solarmodul ist im Modulabschnitt farbig. Als besonders attraktiv gelten Solarmodule mit einem homogenen Farbeindruck auf der gesamten Fläche. Die Farbe des Solarmoduls kann durch drei Farbkoordinaten L*, a*, b* beschrieben werden, wobei sich die Farbkoordinaten auf den dem Fachmann an sich bekannten (CIE)L*a*b*-Farbraum beziehen, in dem alle wahrnehmbaren Farben exakt definiert sind. Dieser Farbraum ist in der europäischen Norm EN ISO 11664-4 "Colorimetry - Part 4:CIE 1976 L*a*b* Colour space" spezifiziert, auf welche im Rahmen der vorliegenden Erfindungsbeschreibung vollumfänglich Bezug genommen wird. Im (CIE)L*a*b*-Farbraum ist jede Farbe durch einen Farbort mit den drei kartesischen Koordinaten L*, a*, b* definiert. Auf der a*-Achse liegen sich Grün und Rot gegenüber, die b*-Achse verläuft zwischen Blau und Gelb, die L*-Achse beschreibt die Helligkeit (Luminanz) der Farbe. Für eine anschaulichere Darstellung können die Größen in den Lhc-Farbraum umgerechnet werden, wobei L gleich bleibt und die Sättigung der Radius und h der Winkel eine Farbpunktes in der a*b*-Ebene ist.

Die Farbe des Solarmoduls bezieht sich auf eine Betrachtung des Solarmoduls von der äußeren Umgebung her, d.h. in Sicht auf die frontseitige Deckplatte. Die Farbmessung bzw. die Bestimmung der Farbkoordinaten des Solarmoduls kann in einfacher Weise durch ein im Handel verfügbares Farbmessgerät (Spektralphotometer) erfolgen. Das Farbmessgerät wird zu diesem Zweck auf die Außenfläche der frontseitigen Deckplatte gerichtet, insbesondere auf die Außenfläche aufgesetzt. Übliche Farbmessgeräte ermöglichen eine normgerechte Farbmessung, wobei deren Aufbau und Toleranzen typischer Weise internationalen Normen unterliegen, beispielsweise definiert durch DIN 5033, ISO/CIE 10527, ISO 7724 und ASTM E1347. Beispielsweise wird hinsichtlich der Farbmessung auf die Norm DIN 5033 vollumfänglich Bezug genommen. Ein Farbmessgerät weist als Lichtquelle beispielsweise eine Xenon-Blitzlampe, Wolfram-Halogenlampe oder ein oder mehrere LEDs auf, wobei die Außenfläche eines Körpers mit dem erzeugten (z.B. Weiß-)Licht beleuchtet und das vom Solarmodul empfangene Licht gemessen wird. Wie eingangs erläutert, ergibt sich die vom Farbmessgerät gemessene Körperfarbe aus dem reflektierten und remittierten Licht des Solarmoduls.

Um zu erreichen, dass das erfindungsgemäße Solarmodul zumindest in einem Abschnitt eine homogene Farbe mit relativ geringer Winkelabängigkeit hat, weist die Außenfläche der transparenten Deckplatte mindestens einen strukturierten Bereich auf, auf dem eine farbgebende (transparente) optische Interferenzschicht zur Reflexion von Licht innerhalb eines vorgegebenen bzw. vorgebbaren Wellenlängenbereichs angeordnet ist. Die optische Interferenzschicht ist vorzugsweise unmittelbar (ohne weitere Zwischenschicht) auf der Außenfläche der Deckplatte angeordnet. Die optische Interferenzschicht kann ein- oder mehrlagig ausgebildet sein, d.h. eine oder mehrere lichtbrechende Lagen (Brechungsschichten) aufweisen. Die optische Interferenzschicht dient zur Erzeugung der Farbe des Solarmoduls, wobei die optische Interferenzschicht so ausgebildet ist, dass eine konstruktive bzw. destruktive Interferenz von Licht, das an den verschiedenen Grenzflächen der optischen Interferenzschicht reflektiert wird, möglich ist. Die Farbe des Solarmoduls ergibt sich aus der Interferenz des an den Grenzflächen der optischen Interferenzschicht reflektierten Lichts. Bei Beleuchtung mit (Weiß-)Licht, insbesondere Sonnenlicht, wirkt die optische Interferenzschicht als Farbfilter zur Erzeugung einer homogenen Farbe. Die fotovoltaisch aktiven Solarzellen, welche beispielsweise eine bläulich-schwarze Färbung aufweisen (CIGS-Dünnschichtsolarzellen), tragen zur Gesamtfarbe des Solarmoduls bei.

Vorzugsweise erstreckt sich der strukturierte Bereich der Außenfläche über die komplette Deckplatte, d.h. über die komplette Außenfläche der Deckplatte, so dass das Solarmodul eine homogene Farbe hat. Das Solarmodul kann auch mehrere Modulabschnitte mit jeweils homogener Farbe aufweisen. Die Farben der Modulabschnitte können gleich oder voneinander verschieden sein.

Der mindestens eine strukturierte Bereich weist senkrecht zur Ebene der Deckplatte ein Höhenprofil mit Bergen (Erhebungen) und Tälern (Einsenkungen) auf, wobei ein mittlerer Höhenunterschied zwischen den Bergen und Tälern mindestens 2 µm und vorzugsweise, jedoch nicht zwingend, maximal 20% einer Dicke der transparenten Deckplatte beträgt. Ferner setzen sich mindestens 50% des strukturierten Bereichs der Außenfläche aus unterschiedlich geneigten Segmenten bzw. Facetten (reflektierende Bereiche der Oberflächen) zusammen. Die Segmente sind Abschnitte der zur äußeren Umgebung gerichteten Oberfläche der Deckplatte und jeweils als plane Flächen ausgebildet, die zur Ebene der Deckplatte geneigt sind. Hierbei haben, bezogen auf die Ebene der Deckplatte, mindestens 20% der Segmente einen Neigungswinkel im Bereich von größer als 0° bis maximal 15° und mindestens 30% der Segmente einen Neigungswinkel im Bereich von größer als 15° bis maximal 45°. Vorteilhaft, jedoch nicht zwingend haben weniger als 30% der Segmente einen Neigungswinkel von größer als 45°. Die Strukturen sind bevorzugt nicht periodisch und anisotrop. Für spezielle optische Effekte können jedoch auch periodische Strukturen und aniostrope Strukturen zur Anwendung kommen. Ferner sind die Segmente jeweils eben (plan) und haben eine Segmentfläche von mindestens 1 µm². Der strukturierte Bereich kann beispielsweise durch Ätzen, Sandstrahlen oder Walzen der Deckplatte hergestellt werden.

Demnach weist der strukturierte Bereich eine Vielzahl von ebenen (planen) Segmenten auf. Im Sinne vorliegender Erfindung können ebene (plane) Segmente durch nichtgekrümmte Flächen gebildet werden. Möglich ist aber auch, dass ebene (plane) Segmente durch geringfügig gekrümmte Flächen gebildet werden. Ein Segment ist im Sinne vorliegender Erfindung dann geringfügig gekrümmt, wenn für jeden Punkt des Segments gilt: wenn an einem Punkt des Segments eine (gedachte) Tangentialebene mit einer Fläche von 1 µm² konstruiert wird, beträgt der Abstand zwischen der Fläche des Segments und der Tangentialebene, bezogen auf die Normalenrichtung zur Tangentialebene, weniger als 50 nm.

Ferner gilt, dass in mindestens einer Zone (d.h. Teilbereich) des strukturierten Bereichs die Segmente jeweils eine mittlere Rauigkeit von weniger als 15% einer Schichtdicke der optischen Interferenzschicht, welche auf den strukturierten Bereich aufgebracht ist, haben. Falls die optische Interferenzschicht aus mehreren Brechungsschichten besteht, haben die Segmente der mindestens einen Zone jeweils eine mittlere Rauigkeit von weniger als 15% einer Schichtdicke der Brechungsschicht mit geringster Schichtdicke. Die Zone, in der die Segmente jeweils eine mittlere Rauigkeit von weniger als 15% der Schichtdicke der optischen Interferenzschicht haben, kann dem strukturierten Bereich entsprechen, d.h. Zone und strukturierter Bereich sind dann identisch.

Im Sinne vorliegender Erfindung bezeichnet der Begriff "Strukturierung" bzw. "strukturierter Bereich" einen Bereich der Außenfläche oder Innenfläche der Deckplatte, in dem die im unmittelbar vorstehenden Absatz beschriebenen Merkmale in Kombination vorliegen.

Durch die Merkmale des strukturierten Bereichs kann in vorteilhafter Weise erreicht werden, dass bei Beleuchtung der Deckplatte mit Licht auch bei einer Beobachtung außerhalb des Glanzwinkels (Einfallswinkel des auftreffenden Lichts entspricht Ausfallswinkel des reflektierten Lichts, bezogen auf die Ebene der Deckplatte) Licht mit relativ hoher Intensität zurückgeworfen wird. Ursache hierfür sind die verschieden geneigten Segmente, die in ausreichender Anzahl, geeigneter Größe und geeigneter Rauigkeit sowie geeigneten Neigungswinkeln vorhanden sind, um eine hohe Intensität des reflektierten Lichts auch bei einer Beobachtung außerhalb des Glanzwinkels zu ermöglichen. Es gibt stets hinreichend viele geneigte Segmente, die bei Strukturierung außen durch Brechung an den Segmenten und bei Strukturierung innen durch Reflexion an den Segmenten genügend Intensität in Richtungen außerhalb des Glanzwinkels der Deckplatte streuen.

Wie hier und im Weiteren verwendet, bezieht sich der Begriff "Glanzwinkel" auf die Normale zur Ebene der Deckplatte, im Unterschied zum "lokalen Glanzwinkel", der sich auf die Normale zur Ebene eines Segments bezieht. Glanzwinkel und lokaler Glanzwinkel können gleich sein (Segment ist parallel zur Ebene der Deckplatte), sind jedoch in aller Regel verschieden (Segment ist geneigt zur Ebene der Deckplatte).

Im Ergebnis kann erreicht werden, dass die Intensität des nicht im Glanzwinkel reflektierten (d.h. gestreuten) Lichts relativ hoch ist und im Vergleich zu einer reflektierenden Oberfläche ohne einen solchen strukturierten Bereich, eine nur geringe Winkelabhängigkeit in Bezug auf die Einstrahl- und Beobachtungsrichtung hat. Mittels der optischen Interferenzschicht kann das außerhalb des Glanzwinkels reflektierte Licht, abhängig von Brechungsindex und Schichtdicke der optischen Interferenzschicht, einer Farbselektion unterzogen werden, so dass die Oberfläche der Deckplatte eine homogene Farbe mit relativ geringer Winkelabhängigkeit hat.

In dieser Hinsicht vorteilhaft weist der strukturierte Bereich ein Höhenprofil auf, bei dem ein mittlerer Höhenunterschied zwischen den Bergen und Tälern mindestens 2 µm, bevorzugt mindestens 10 µm und besonders bevorzugt mindestens 15 µm beträgt. Ein derart strukturierter Bereich kann durch Ätzen der Deckplatte (z.B. Deckglas) erzeugt werden. In dieser Hinsicht gleichermaßen vorteilhaft weist der strukturierte Bereich ein Höhenprofil auf, bei dem ein mittlerer Höhenunterschied zwischen den Bergen und Tälern mindestens 50 µm, bevorzugt mindestens 100 µm beträgt. Ein derart strukturierter Bereich kann durch Walzen der Deckplatte (z.B. Deckglas) erzeugt werden. Dementsprechend erstreckt sich die Erfindung vorteilhaft auf ein Fassadenelement, dessen mindestens ein strukturierter Bereich der Deckplatte durch Ätzen oder Walzen hergestellt ist, wodurch die genannten Höhenprofile herstellbar sind. Die Strukturen können aber auch durch das Aufbringen einer transparenten und strukturierten Schicht auf die Deckplatte erzeugt werden. Die Schicht muss dabei einen gleichen (oder zumindest sehr ähnlichen) Brechungsindex haben wie die Deckplatte. Erfindungsgemäß soll das Strukturieren einer Oberfläche der Deckplatte auch das Aufbringen einer solchen transparenten und strukturierten Schicht umfassen.

Die genannten Eigenschaften des strukturierten Bereichs der Deckplatte können durch herkömmliche Messgeräte, wie ein Mikroskop, insbesondere ein Konfokalmikroskop, oder ein Nadelprofilometter, bestimmt werden.

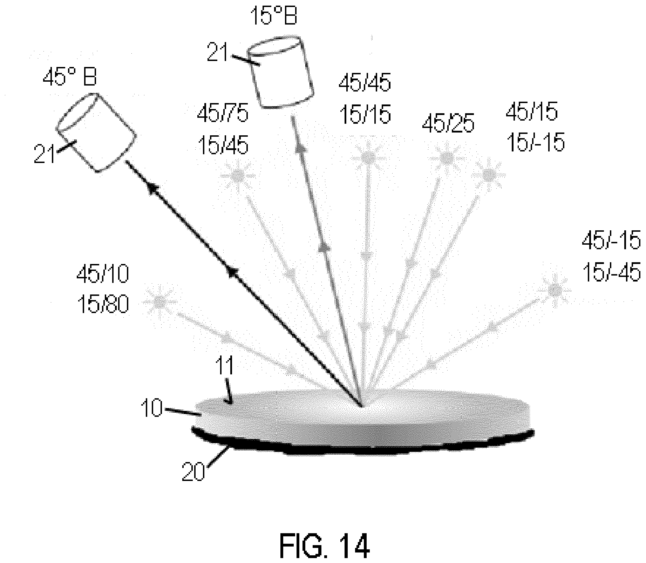

Vorzugsweise wird durch den mindestens einen strukturierten Bereich der (unbeschichteten) Deckplatte des erfindungsgemäßen Solarmoduls erreicht, dass bei Beobachtungswinkeln von 45° und 15° (jeweils bezogen auf die Normale zur Ebene der Deckplatte) und einem Einfallswinkel, der um 45° (in beiden Richtungen) vom jeweiligen Glanzwinkel abweicht, eine Helligkeit L des reflektierten Lichts von mindestens 10 auftritt. Vorzugsweise tritt eine Helligkeit L des reflektierten Lichts von mindestens 15 und stärker bevorzugt mindestens 20 auf. Bei dieser Messung ist auf der von der zu charakterisierenden Seite abgewandten Seite der (unbeschichteten) Deckplatte eine schwarze Abdeckung angebracht. Für die Messung wird ein D65-Strahler verwendet und mit einem im Handel verfügbaren Mehrwinkel-Farbmessgerät die Helligkeit L gemessen (10° Öffnungswinkel). Der Messaufbau wird weiter unten in Verbindung mit Figur 14 näher erläutert. In diesem Zusammenhang wird auf die europäische Norm EN ISO 11664-4 in vollem Umfang Bezug genommen.

Die Erfindung erstreckt sich demnach auf ein Solarmodul zur fotovoltaischen Energieerzeugung, welches eine transparente Deckplatte mit einer der äußeren Umgebung zugewandten Außenfläche und einer gegenüberliegenden Innenfläche umfasst, wobei die Außenfläche mindestens einen strukturierten Bereich aufweist, auf dem eine optische Interferenzschicht zur Reflexion von Licht innerhalb eines vorgegebenen Wellenlängenbereichs angeordnet ist, wobei der strukturierte Bereich folgende Merkmale hat:
- senkrecht zur Ebene der Deckplatte ein Berge und Täler aufweisendes Höhenprofil, wobei ein mittlerer Höhenunterschied zwischen den Bergen und Tälern mindestens 2 µm beträgt,
- mindestens 50% des strukturierten Bereichs setzt sich aus Segmenten zusammen, die zur Ebene der Deckplatte geneigt sind, wobei, bezogen auf die Ebene der Deckplatte, mindestens 20% der Segmente einen Neigungswinkel im Bereich von größer als 0° bis maximal 15° und mindestens 30% der Segmente einen Neigungswinkel im Bereich von größer als 15° bis maximal 45° haben, wobei
- die Segmente jeweils eben sind und eine Segmentfläche von mindestens 1 µm² haben, wobei die Segmente jeweils eine mittlere Rauigkeit von weniger als 15% einer Schichtdicke der optischen Interferenzschicht auf der Außenfläche haben.

Hierbei ist es von Vorteil, wenn die mit einer schwarzen Rückfläche versehene, strukturierte, unbeschichtete Deckplatte so ausgebildet ist, dass bei einem Beobachtungswinkel von 45° und 15° (jeweils bezogen auf die Normale zur Ebene der Deckplatte) und einem Einfallswinkel, der um 45° (in beiden Richtungen) vom jeweiligen Glanzwinkel abweicht, eine Helligkeit L des reflektierten Lichts von mindestens 10, mindestens 15 oder mindestens 20 auftritt.

Die Erfindung erstreckt sich gleichermaßen auf ein Solarmodul zur fotovoltaischen Energieerzeugung, welches eine transparente Deckplatte mit einer der äußeren Umgebung zugewandten Außenfläche und einer gegenüberliegenden Innenfläche umfasst, wobei die Außenfläche mindestens einen strukturierten Bereich aufweist, auf dem eine optische Interferenzschicht zur Reflexion von Licht innerhalb eines vorgegebenen Wellenlängenbereichs angeordnet ist, wobei die mit einer schwarzen Rückfläche versehene, mindestens einen strukturierten Bereich aufweisende, unbeschichtete Deckplatte so ausgebildet ist, dass bei einem Beobachtungswinkel von 45° und 15° (jeweils bezogen auf die Normale zur Ebene der Deckplatte) und einem Einfallswinkel, der um 45° vom jeweiligen Glanzwinkel (in beiden Richtungen) abweicht, eine Helligkeit L des reflektierten Lichts von mindestens 10, mindestens 15 oder mindestens 20 auftritt.

Erfindungsgemäß kann der eingangs beschriebene Zielkonflikt zwischen einer homogenen Farbe mit geringer Winkelabhängigkeit und gleichzeitig hohem Wirkungsgrad des Solarmoduls sehr zufriedenstellend gelöst werden. Einerseits wird durch die strukturierte Oberfläche der Deckplatte Licht mit einer hohen Intensität und geringer Winkelabhängigkeit auch außerhalb des Glanzwinkels reflektiert. Andererseits wird durch die Filterwirkung der optischen Interferenzschicht ermöglicht, dass Licht mit hoher Intensität auf den fotovoltaisch aktiven Halbleiter der Solarzellen treffen kann, so dass ein großer Anteil des auftreffenden Lichts mit hohem Wirkungsgrad bzw. möglichst geringem Wirkungsgradverlust des Solarmoduls in elektrischen Strom umwandelbar ist. Zudem wird durch die farbgebende optische Interferenzschicht ein guter homogener Farbeindruck erreicht. Die Interferenzschicht wirkt als Filter mit möglichst schmalbandiger Reflexion und einer breitbandigen Transmission.

Bei einer bevorzugten Ausgestaltung des erfindungsgemäßen Solarmoduls ist die Außenfläche der Deckplatte mit mindestens einem strukturierten Bereich versehen, auf dem eine farbgebende optische Interferenzschicht angeordnet ist. Zudem weist die Innenfläche der Deckplatte keinen strukturierten Bereich und keine optische Interferenzschicht auf. Die Innenfläche ist vorzugsweise glatt (im Rahmen der Produktionsungenauigkeiten). Die optische Interferenzschicht ist vorzugsweise unmittelbar (d.h. ohne weitere Zwischenschicht) auf der Außenfläche der Deckplatte angeordnet.

Bei einer weiteren bevorzugten Ausgestaltung des erfindungsgemäßen Solarmoduls ist die Außenfläche der Deckplatte mit mindestens einem strukturierten Bereich versehen, auf dem eine farbgebende optische Interferenzschicht angeordnet ist. Zudem weist die Innenfläche keinen strukturierten Bereich auf, wobei auf der Innenfläche der Deckplatte eine weitere optische Interferenzschicht zur Reflexion von Licht innerhalb eines vorgegebenen Wellenlängenbereichs angeordnet ist. Die Innenfläche ist vorzugsweise glatt (im Rahmen der Produktionsungenauigkeiten). Obige Ausführungen zur optischen Interferenzschicht auf der Außenfläche der Deckplatte gelten in analoger Weise für die optische Interferenzschicht auf der Innenfläche der Deckplatte. Die beiden optischen Interferenzschichten können gleich oder voneinander verschieden sein. Insbesondere können die beiden optischen Interferenzschichten zur Reflexion von Licht innerhalb eines selben Wellenlängenbereichs ausgebildet sein. Möglich ist jedoch auch, dass die beiden optischen Interferenzschichten zur Reflexion von Licht innerhalb verschiedener oder nur teilweise überlappender Wellenlängenbereiche ausgebildet sind. Die Schichtdicken und Brechungsindizes der beiden optischen Interferenzschichten können gleich oder voneinander verschieden sein. Durch diese Maßnahme kann die Farbe des Solarmoduls noch besser definiert werden. Zudem können Mischfarben generiert werden.

Bei einer weiteren bevorzugten Ausgestaltung des erfindungsgemäßen Solarmoduls ist die Außenfläche der Deckplatte mit mindestens einem strukturierten Bereich versehen, auf dem eine farbgebende optische Interferenzschicht angeordnet ist. Zudem weist die Innenfläche mindestens einen strukturierten Bereich auf, auf dem eine optische Interferenzschicht zur Reflexion von Licht innerhalb eines vorgegebenen Wellenlängenbereichs angeordnet ist. Obige Ausführungen zum strukturierten Bereich der Außenfläche der Deckplatte gelten in analoger Weise für den strukturierten Bereich der Innenfläche der Deckplatte. Der strukturierte Bereich der Innenfläche und der strukturierte Bereich der Außenfläche können gleich oder voneinander verschieden sein. Für die weitere optische Interferenzschicht auf der Innenfläche der Deckplatte gelten die diesbezüglichen Ausführungen in unmittelbar vorgestehender Ausgestaltung des Solarmoduls in analoger Weise, wobei die Schichtdicken und Brechungsindizes der beiden optischen Interferenzschichten gleich oder voneinander verschieden sein können. Auch durch diese Maßnahmen kann die Farbe des Solarmoduls noch besser definiert werden. Zudem können Mischfarben generiert werden.

In dem erfindungsgemäßen Solarmodul wird durch die mindestens eine strukturierte Oberfläche der Deckplatte Licht mit einer hohen Intensität und geringer Winkelabhängigkeit auch außerhalb des Glanzwinkels reflektiert. Durch die mindestens eine optische Interferenzschicht, welche farbgebend wirkt, wird ein sehr homogener Farbeindruck erzeugt. Allen oben beschriebenen Ausgestaltung ist gemeinsam, dass bereits beim Auftreten des Lichtes auf die strukturierte Außenfläche mit Interferenzschicht durch Reflexion und Interferenz eine Farbe mit hohen Intensität und geringer Winkelabhängigkeit auch außerhalb des Glanzwinkels entsteht. Die zusätzliche Interferenzschicht und/oder Strukturierung auf der Innenfläche können diese Wirkung noch verstärken.

Bei einer vorteilhaften Ausgestaltung des erfindungsgemäßen Solarmoduls setzen sich mindestens 80%, besonders bevorzugt mindestens 90%, eines strukturierten Bereichs der Außenfläche oder der Innenfläche (je nachdem welche Fläche strukturiert ist) aus zur Ebene der Deckplatte geneigten Segmenten zusammen. Durch die Vergrößerung der Anzahl der Segmente kann die Intensität des vom strukturierten Bereich der Oberfläche der Deckplatte auch außerhalb des Glanzwinkels reflektierten Lichts und dessen Winkelstabilität noch weiter gesteigert werden.

Bei einer weiteren vorteilhaften Ausgestaltung des erfindungsgemäßen Solarmoduls haben mindestens 30% der Segmente mindestens eines strukturierten Bereichs einen Neigungswinkel im Bereich von größer als 0° bis maximal 15°, mindestens 40% der Segmente einen Neigungswinkel im Bereich von größer als 15° bis maximal 45° und vorzugsweise, jedoch nicht zwingend, weniger als 10% der Segmente einen Neigungswinkel von größer als 45°. Besonders bevorzugt haben mindestens 40% der Segmente einen Neigungswinkel im Bereich von größer als 0° bis maximal 15°, mindestens 50% der Segmente einen Neigungswinkel im Bereich von größer als 15° bis maximal 45° und vorzugsweise, jedoch nicht zwingend, weniger als 10% der Segmente einen Neigungswinkel von größer als 45°. Falls relativ viele Facetten mit einem kleinen Neigungswinkel von weniger als 15° vorliegen, tritt (wie bei einer unstrukturierten Oberfläche) im Wesentlichen nur eine reflektierte Intensität bei einem Beobachtungswinkel nahe des Glanzwinkels auf, was erfindungsgemäß nicht erwünscht ist. Bei steileren Facetten verringert sich die Winkelabhängigkeit des reflektierten Lichts, jedoch können bei zahlreichen sehr steilen Facetten (größer als 45°) verstärkt Mehrfach-Reflexionen auftreten, was nachteilig ist, da dies in stärkerem Maße zur Einkopplung auch desjenigen Anteils des Lichtes in die Absorberschicht führen kann, dessen Reflexion im Sinne der vorliegenden Erfindung erwünscht ist. Zudem ist es bei vielen Beschichtungsverfahren schwierig, eine konforme Bedeckung mit gleicher Schichtdicke gleichzeitig auf flachen und steile Oberflächensegmente zu gewährleisten. Die Schichtdicke der optischen Interferenzschicht würde also vom Neigungswinkel abhängen, was wiederum zu unerwünschten Winkelabhängigkeiten führt. In dieser Hinsicht am meisten bevorzugt ist eine Ausgestaltung, bei der die Segmente jeweils einen Neigungswinkel aufweisen, der größer als 0° ist und maximal 45° beträgt. Gemäß vorstehender Bedingungen kann eine sehr hohe Intensität des reflektierten Lichts auch au-ßerhalb des Glanzwinkels bei zugleich besonders geringer Winkelabhängigkeit der Intensität erreicht werden.

Die Strukturen sind bevorzugt nicht-periodisch und anisotrop. Für spezielle optische Effekte können jedoch auch periodische Strukturen und/oder anisotrope Strukturen zur Anwendung kommen. Periodische und anisotrope Strukturen wie Pyramiden, tetragonale oder hexagonale Wabenstrukturen oder Halbkugeln lassen sich gut mit Walzen beim Glasziehen herstellen. Sie können zu attraktiven Glanz und Farbeffekten verwendet werden. Wenn die Oberflächenstrukturen die oben genannten Bedingungen erfüllen, zeigen die Solarmodule wiederum eine deutlich verringerte Abnahme der Farbigkeit für Winkel außerhalb der Glanzwinkel, jedoch sind die Winkelabhängigkeiten dann anisotrop in Bezug auf die Orientierung in der Modulebene.

Die mindestens eine optische Interferenzschicht kann eine oder mehrere Brechungsschichten enthalten und insbesondere aus diesen bestehen. Eine Brechungsschicht besteht aus einem selben Material (mit gleicher Zusammensetzung) und weist insbesondere über die Schichtdicke hinweg einen homogenen (gleichen) Brechungsindex auf. Enthält die optische Interferenzschicht mehrere Brechungsschichten, bestehen mindestens zwei Brechungsschichten aus einem voneinander verschiedenen Material und haben einen unterschiedlichen Brechungsindex. Vorteilhaft weist mindestens eine Brechungsschicht einen Brechungsindex n von größer als 1,7, vorzugsweise größer als 2,0 und besonders bevorzugt größer als 2,3 auf. Grundsätzlich gilt, dass je größer der Brechungsindex ist, desto geringer ist die Winkelabhängigkeit des reflektierten Lichts, so dass die Winkelabhängigkeit des Farbeindrucks weiter reduziert werden kann.

Vorteilhaft enthält die optische Interferenzschicht mindestens eine Verbindung, gewählt aus TiOₓ, ZrOₓ, SiC und Si₃N₄. Weist die optische Interferenzschicht zwei, drei oder mehr Lagen auf, enthält die optische Interferenzschicht vorzugsweise mindestens eine Verbindung, gewählt aus MgF₂, Al₂O₃, SiO₂ und Siliziumoxinitrid. Dies sind Verbindungen mit einem relativ niedrigen Brechungsindex.

In dem erfindungsgemäßen Solarmodul kann aufgrund der Kombination einer strukturierten Oberfläche mit einer optischen Interferenzschicht, die nur eine geringe Anzahl an Brechungsschichten aufweist (z.B. ein bis drei Brechungsschichten) schon ein guter Farbeindruck erreicht werden. Durch die geringe Anzahl an Brechungsschichten wird die Herstellung des Solarmoduls vereinfacht und die Produktionskosten verringern sich.

Vorteilhaft enthält mindestens eine optische Interferenzschicht (insbesondere alle optischen Interferenzschichten) des Solarmoduls genau eine Brechungsschicht (oder besteht aus dieser), deren Brechungsindex n größer als 1,9, bevorzugt größer als 2,3, ist.

Gleichermaßen vorteilhaft enthält mindestens eine optische Interferenzschicht (insbesondere alle optischen Interferenzschichten) des Solarmoduls genau zwei Brechungsschichten (oder besteht aus diesen), wobei eine erste Brechungsschicht mit einen ersten Brechungsindex n1 auf der Deckplatte mit einem Brechungsindex nd vorliegt und eine zweite Brechungsschicht mit einem zweiten Brechungsindex n2 auf der ersten Brechungsschicht vorliegt. Für die Beträge (Absolutwerte) der Differenzen der Brechungsindizes gilt: |n1-nd| > 0,3 und |n2-n1| > 0,3 und mindestens einer der Brechungsindizes n1 oder n2 ist größer als 1,9, bevorzugt größer als 2,3.

Gleichermaßen vorteilhaft enthält mindestens eine optische Interferenzschicht (insbesondere alle optischen Interferenzschichten) des Solarmoduls genau drei Brechungsschichten (oder besteht aus diesen), wobei eine erste Brechungsschicht mit einen ersten Brechungsindex n1 auf der Deckplatte mit einem Brechungsindex nd vorliegt, eine zweite Brechungsschicht mit einem zweiten Brechungsindex n2 auf der ersten Brechungsschicht vorliegt und eine dritte Brechungsschicht mit einem dritten Brechungsindex n3 auf der zweiten Brechungsschicht vorliegt. Für die Beträge (Absolutwerte) der Differenzen der Brechungsindizes gilt: |n3-n2| > 0,3 und |n2-n1| > 0,3 und |n1-nd| > 0,3. Dabei verhalten sich die Werte der Brechungsindizes alternierend: entweder gilt n1 > n2 und n3 > n2 oder es gilt n1 < n2 und n3 < n2. Zudem ist mindestens einer der Brechungsindizes n1, n2 oder n3 größer als 1,9, bevorzugt größer als 2,3.

Durch die optischen Interferenzschichten mit genau einer, genau zwei oder genau drei Brechungsschichten kann bei vereinfachter Herstellung und geringeren Produktionskosten des Solarmoduls ein homogener Farbeindruck des Solarmoduls erzielt werden. Durch zwei- oder dreilagige Schichten kann die Farbkraft, d.h. Helligkeit und Sättigung, also die Reflexion in einem bestimmten engen Wellenbereich erhöht werden. Durch relativ hohe Brechungsindizes wird die Winkelabhängigkeit reduziert. Interferenzschichten aus Schichtstapeln mit mehr als drei Schichten in Kombination mit der erfindungsgemäß strukturierten Deckplatte und den dargestellten Ausgestaltungen liegen ebenfalls im Bereich der Erfindung, sind aber komplexer in der Herstellung. Mit einer Vierfachschicht aus Brechschichten mit alternierend hohen und niedrigen Brechungsindizes kann beispielsweise die Bandbreite des reflektierten Lichts noch weiter reduziert werden bei verbesserter Transmission.

Im strukturierten Bereich der Deckplatte tritt eine Reflexion der einfallenden Lichtstrahlung auch außerhalb des Glanzwinkels mit relativ hoher Intensität auf. Der strukturierte Bereich ist zu diesem Zweck vorzugsweise so ausgebildet, dass ein Reflexions-Haze von mehr als 50%, besonders bevorzugt mehr als 90%, vorliegt. Der Reflexions-Haze lässt sich durch ein im Handel verfügbares Haze-Messgerät bestimmen. Nach ASTM D1003 ist Haze das Verhältnis aus diffusem Anteil des reflektierten Lichts zur Gesamtreflexion.

In dem erfindungsgemäßen Solarmodul ist mindestens eine Zone vorgesehen, in der die Segmente eine mittlere Rauigkeit von weniger als 15% der Schichtdicke der optischen Interferenzschicht auf der Außenfläche haben, wodurch eine konstruktive bzw. destruktive Interferenz des reflektierten Lichts ermöglicht ist. Vorteilhaft erstreckt sich diese Zone über die gesamte Deckplatte. Gemäß einer Ausgestaltung der Erfindung weist der strukturierte Bereich mindestens eine weitere Zone, d.h. (Teil-)Bereich, auf, in dem die Segmente jeweils eine solche mittlere Rauigkeit aufweisen, dass eine Interferenz an der optischen Interferenzschicht nicht auftritt. Beispielsweise haben die Segmente dort eine mittlere Rauigkeit von 50% bis 100% der Schichtdicke der Interferenzschicht. In diesen Zonen weist das Solarmodul keine durch die optische Interferenzschicht erzeugte Farbe auf.

Die Erfindung bezieht sich weiterhin auf ein Verfahren zur Herstellung eines erfindungsgemäßen Solarmoduls wie es vorstehend beschrieben ist. Das erfindungsgemäße Verfahren umfasst zur Bearbeitung der Deckplatte die folgenden Schritte:
In einem ersten Verfahrensschritt a) wird eine ebene transparente Deckplatte bereitgestellt, die eine Außenfläche, welche der äußeren Umgebung zugewandt sein soll, und eine gegenüberliegende Innenfläche aufweist.

Anschließend wird aus den folgenden drei (alternativen) Verfahrensschritten ein einziger zweiter Verfahrensschritt b1), b2) oder b3) ausgewählt und durchgeführt:
b1) Strukturieren der Außenfläche mindestens in einem Bereich und Aufbringen einer optischen Interferenzschicht auf den strukturierten Bereich. In diesem Fall wird die Innenfläche nicht strukturiert und keine optische Interferenzschicht auf die Innenfläche aufgebracht.
b2) Strukturieren der Außenfläche mindestens in einem Bereich, Aufbringen einer optischen Interferenzschicht auf den strukturierten Bereich der Außenfläche und Aufbringen einer weiteren optischen Interferenzschicht auf die Innenfläche. In diesem Fall wird die Innenfläche nicht strukturiert.
b3) Strukturieren der Außenfläche mindestens in einem Bereich, Aufbringen einer optischen Interferenzschicht auf den strukturierten Bereich der Außenfläche, Strukturieren der Innenfläche mindestens in einem Bereich und Aufbringen einer weiteren optischen Interferenzschicht auf den strukturierten Bereich der Innenfläche.

In obigem Verfahren umfasst das Strukturieren der Außenfläche bzw. Innenfläche auch das Aufbringen einer mit mindestens einem strukturierten Bereich versehenen, transparenten Schicht auf die Deckplatte, welche die Außenfläche bzw. Innenfläche bildet.

Des Weiteren erstreckt sich die Erfindung auf die Verwendung des erfindungsgemäßen Solarmoduls als (integraler) Bestandteil einer Gebäudehülle (Gebäudewand) oder einer freistehenden Wand, beispielsweise eine Sichtschutz- oder Lärmschutzwand.

Die verschiedenen Ausgestaltungen der Erfindung können einzeln oder in beliebigen Kombinationen realisiert sein. Insbesondere sind die vorstehend genannten und nachstehend zu erläuternden Merkmale nicht nur in den angegebenen Kombinationen, sondern auch in anderen Kombinationen oder in Alleinstellung einsetzbar, ohne den Rahmen der vorliegenden Erfindung zu verlassen.

Die Erfindung wird im Weiteren näher erläutert, wobei Bezug auf die beigefügten Zeichnungen genommen wird. Es zeigen in vereinfachter, nicht maßstäblicher Darstellung:
- Fig. 1: ein Ausführungsbeispiel für ein erfindungsgemäßes Solarmodul in einer schematischen Querschnittansicht;
- Fig. 2: den Grundaufbau des erfindungsgemäßen Solarmoduls in schematischer Querschnittansicht;
- Fig. 3: ein vergrößerter Ausschnitt der Deckplatte des Solarmoduls von Figur 2 in schematischer Querschnittansicht;
- Fig. 4: eine schematische Darstellung typischer Lichtverhältnisse eines als Fassadenelement ausgebildeten Solarmoduls;
- Fig. 5-8: schematische Darstellungen beispielhafter Lichtwege bei Reflexion an der Deckplatte des Solarmoduls von Figur 2;
- Fig. 9: eine schematische Darstellung der Interferenz von Lichtstrahlen in der optischen Interferenzschicht;
- Fig. 10-13: verschiedene Ausgestaltungen des erfindungsgemäßen Solarmoduls;
- Fig. 14: eine schematische Darstellung des Messverfahrens zur Mehrwinkel-Farbmessung;
- Fig. 15: ein Diagramm zur Darstellung der Messwerte einer winkelabhängigen Messung der Helligkeit von vier verschiedenen Glasscheiben;
- Fig. 16-17: Höhenprofile verschiedener Glasscheiben;
- Fig. 18: ein Diagramm zur Darstellung der Winkelverteilungen der Segmente verschiedener Glasscheiben;
- Fig. 19-23: Diagramme zur Darstellung verschiedener Eigenschaften optischer Interferenzschichten;
- Fig. 24: ein Ablaufdiagramm zur Veranschaulichung des erfindungsgemäßen Verfahrens.

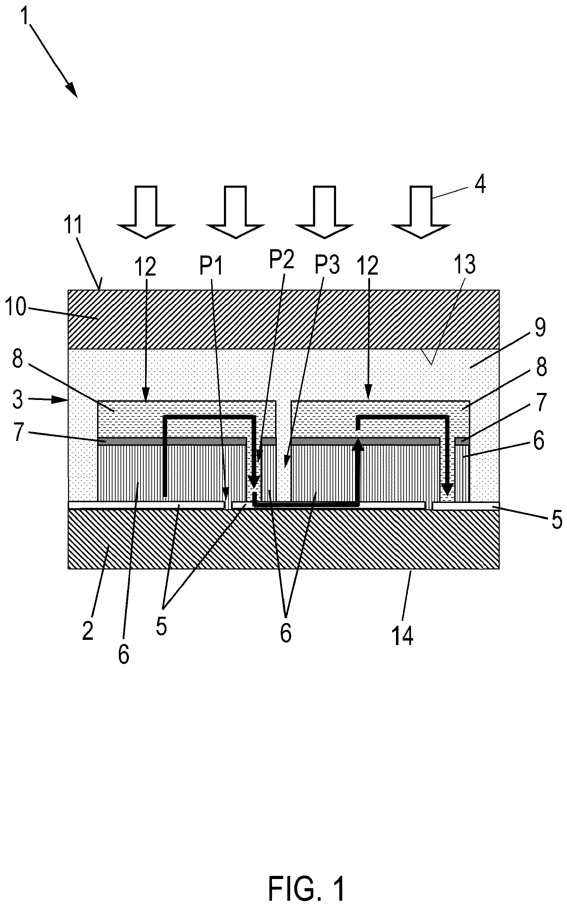

In Figur 1 ist ein insgesamt mit der Bezugszahl 1 bezeichnetes Solarmodul gemäß vorliegender Erfindung in schematischer Weise anhand einer Querschnittansicht (Schnitt senkrecht zur Moduloberfläche) veranschaulicht. Das beispielhaft in Form eines Dünnschichtsolarmoduls ausgebildete Solarmodul 1 umfasst eine Mehrzahl von in integrierter Form seriell miteinander verschalteten Solarzellen 12, von denen in stark vereinfachter Weise nur zwei dargestellt sind. Es versteht sich, dass im Solarmodul 1 in aller Regel eine Vielzahl von Solarzellen 12 (beispielsweise ca. 100-150) seriell verschaltet sind. Das Solarmodul 1 weist eine Verbundscheibenstruktur in Substratkonfiguration auf. Es umfasst ein rückseitiges Substrat 2 mit einem darauf aufgebrachten Schichtenaufbau 3 aus dünnen Schichten, wobei der Schichtenaufbau 3 auf einer lichteintrittsseitigen Oberfläche des Substrats 2 angeordnet ist. Das Substrat 2 ist hier beispielsweise als starre, ebene Glasplatte mit einer relativ hohen Lichtdurchlässigkeit ausgebildet, wobei gleichermaßen andere elektrisch isolierende Materialien mit gewünschter Festigkeit und inertem Verhalten gegenüber den durchgeführten Prozessschritten eingesetzt werden können.

Der Schichtenaufbau 3 umfasst eine auf der Oberfläche des Substrats 2 angeordnete opake Rückelektrodenschicht 5, die beispielsweise aus einem lichtundurchlässigen Metall wie Molybdän (Mo) besteht und durch Aufdampfen oder magnetfeldunterstützte Kathodenzerstäubung (Sputtern) auf das Substrat 2 aufgebracht wurde. Die Rückelektrodenschicht 5 hat beispielsweise eine Schichtdicke im Bereich von 300 nm bis 600 nm. Auf der Rückelektrodenschicht 5 ist eine fotovoltaisch aktive (opake) Absorberschicht 6 aufgebracht, die aus einem mit Metallionen dotierten Halbleiter besteht, dessen Bandabstand in der Lage ist, einen möglichst großen Anteil des Sonnenlichts zu absorbieren. Die Absorberschicht 6 besteht beispielsweise aus einem p-leitenden Chalkopyrit-Halbleiter, beispielsweise eine Verbindung der Gruppe Cu(In/Ga)(S/Se)₂, insbesondere Natrium(Na)-dotiertes Cu(In/Ga)(S/Se)₂. In vorstehender Formel können Indium (In) und Gallium (Ga) sowie Schwefel (S) und Selen (Se) wahlweise oder in Kombination vorhanden sein. Die Absorberschicht 6 hat eine Schichtdicke, die beispielsweise im Bereich von 1-5 µm liegt und insbesondere ca. 2 µm beträgt. Für die Herstellung der Absorberschicht 6 werden typischer Weise verschiedene Materiallagen beispielsweise durch Sputtern aufgebracht, die anschließend durch Erwärmen in einem Ofen, gegebenenfalls in einer S- und/oder Se-haltigen Atmosphäre, zum Verbindungshalbleiter thermisch umgesetzt werden (RTP = Rapid Thermal Processing). Dem Fachmann ist diese Art der Herstellung eines Verbindungshalbleiters wohlbekannt, so dass hier nicht näher darauf eingegangen werden muss. Auf die Absorberschicht 6 ist eine Pufferschicht 7 abgeschieden, die hier beispielsweise aus einer Einzellage Cadmiumsulfid (CdS) und einer Einzellage aus intrinsischem Zinkoxid (i-ZnO) besteht, was in Figur 1 nicht näher dargestellt ist. Auf die Pufferschicht 7 ist eine Frontelektrodenschicht 8 beispielsweise durch Sputtern aufgebracht. Die Frontelektrodenschicht 8 ist für Strahlung im sichtbaren Spektralbereich transparent ("Fensterelektrode"), so dass das einstrahlende Sonnenlicht 4 (in Fig. 1 durch Pfeile veranschaulicht) nur gering geschwächt wird. Die Frontelektrodenschicht 8 basiert beispielsweise auf einem dotierten Metalloxid, beispielsweise n-leitendes Aluminium (Al)-dotiertes Zinkoxid (ZnO). Eine solche Frontelektrodenschicht 8 wird allgemein als TCO-Schicht (TCO = Transparent Conductive Oxide) bezeichnet. Die Schichtdicke der Frontelektrodenschicht 8 beträgt beispielsweise ca. 500 nm. Durch die Frontelektrodenschicht 8 wird gemeinsam mit der Pufferschicht 7 und der Absorberschicht 6 ein Heteroübergang (d.h. Abfolge von Schichten vom entgegen gesetzten Leitungstyp) gebildet. Dabei kann die Pufferschicht 7 eine elektronische Anpassung zwischen der Absorberschicht 6 und der Frontelektrodenschicht 8 bewirken.

Zum Schutz vor Umwelteinflüssen ist auf dem Schichtenaufbau 3 eine (Kunststoff-)Klebeschicht 9 aufgebracht, die zur Verkapselung des Schichtenaufbaus 3 dient. Verklebt mit der Klebeschicht 9 ist eine für Sonnenlicht transparente front- bzw. lichteintrittsseitige Deckplatte 10, die hier beispielsweise in Form einer starren (ebenen) Glasplatte aus extraweißem Glas mit geringem Eisengehalt ausgebildet ist. Die Deckplatte 10 dient zur Versiegelung und für einen mechanischen Schutz des Schichtenaufbaus 3. Die Deckplatte 10 verfügt über eine den Solarzellen 12 zugewandte Innenfläche 13 und eine von den Solarzellen 12 abgewandte Außenfläche 11, welche gleichzeitig die Moduloberfläche bzw. Moduloberseite ist. Über die Außenfläche 11 kann das Solarmodul 1 Sonnenlicht 4 aufnehmen, um an resultierenden Spannungsanschlüssen (+,-) eine elektrische Spannung zu erzeugen. Ein Strompfad ist in Fig. 1 durch seriell angeordnete Pfeile veranschaulicht. Die Deckplatte 10 und das Substrat 2 sind durch die Klebeschicht 9 fest miteinander verbunden ("laminiert"), wobei die Klebeschicht 9 hier beispielsweise als thermoplastische Klebeschicht ausgebildet ist, die durch Erwärmen plastisch verformbar wird und beim Abkühlen die Deckplatte 10 und das Substrat 2 fest miteinander verbindet. Die Klebeschicht 9 kann im Herstellungsprozess als Laminierfolie bereitgestellt werden und besteht hier beispielsweise aus PVB. Die Deckplatte 10 und das Substrat 2 mit den in die Klebeschicht 9 eingebetteten Solarzellen 12 formen gemeinsam einen laminierten Verbund. Die Modulrückseite 14 ist durch die den Solarzellen 12 abgewandte Oberfläche des Substrats 2 gegeben.

Für die Ausbildung und Serienverschaltung der Solarzellen 12 ist der Schichtenaufbau 3 unter Einsatz einer geeigneten Strukturierungstechnologie, beispielsweise Laserschreiben und/oder mechanische Abtragung, strukturiert. Es ist gängig zu diesem Zweck unmittelbare Abfolgen von jeweils drei Strukturierungslinien P1-P2-P3 in den Schichtenaufbau 3 einzubringen. Hierbei wird durch erste Strukturierungslinien P1 mindestens die Rückelektrodenschicht 5 unterteilt, wodurch die Rückelektroden der Solarzellen 12 erzeugt werden. Durch zweite Strukturierungslinien P2 wird mindestens die Absorberschicht 6 unterteilt, wodurch die fotovoltaisch aktiven Bereiche (Absorber) der Solarzellen 12 erzeugt werden. Durch dritte Strukturierungslinien P3 wird mindestens die Frontelektrodenschicht 8 unterteilt, wodurch die Frontelektroden der Solarzellen 12 erzeugt werden. Mittels der zweiten Strukturierungslinie P2 ist die Frontelektrode einer Solarzelle 12 mit der Rückelektrode einer angrenzenden Solarzelle 12 elektrisch verbunden, wobei die Frontelektrode die Rückelektrode beispielsweise direkt kontaktiert. In dem Ausführungsbeispiel von Figur 1 sind die Gräben der ersten Strukturierungslinien P1 durch Material der Absorberschicht 6 verfüllt. Die Gräben der zweiten Strukturierungslinien P2 sind durch Material der Frontelektrodenschicht 8 verfüllt und die Gräben der dritten Strukturierungslinien P3 sind durch die Klebeschicht 9 verfüllt. Jede unmittelbare Abfolge aus erster, zweiter und dritter Strukturierungslinie P1-P2-P3 bildet eine Strukturierungszone zur Serienverschaltung zweier unmittelbar benachbarter Solarzellen 12.

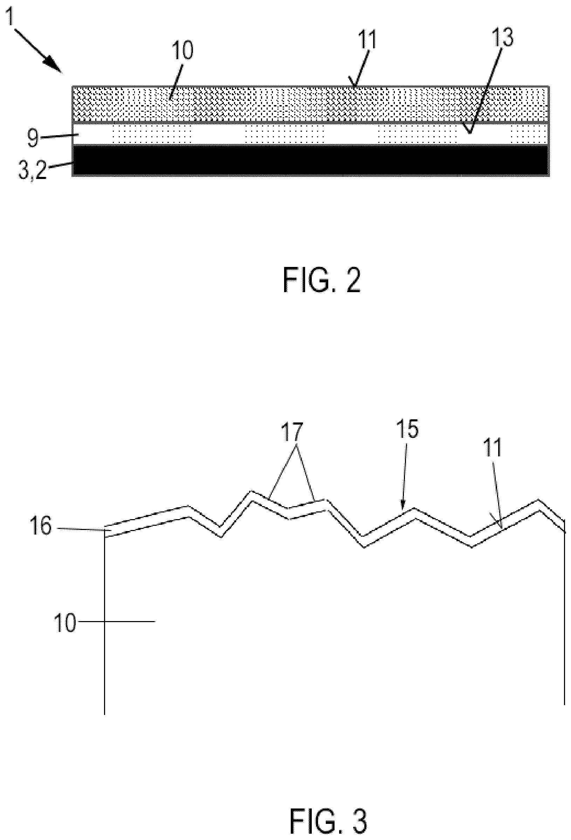

Es wird nun Bezug auf Figur 2 genommen, worin der grundsätzliche Aufbau des erfindungsgemäßen Solarmoduls 1 gezeigt ist. Das Solarmodul 1 umfasst die Deckplatte 10 (z.B. Frontglas) und den auf das rückseitige Substrat 2 aufgebrachten Schichtenaufbau 3, die durch die Klebeschicht 9 (Laminierungsfolie) fest miteinander verbunden sind. Das farbgebende Element ist die beschichtete Deckplatte 10, deren Außenfläche 11 gegen das einfallende Licht zeigt und deren Innenfläche 13 über die Klebeschicht 9 mit den fotovoltaischen Solarzellen (Siliziumwafer oder Dünnschichtsolarzellen) verbunden ist. Das Solarmodul 1 kann insbesondere wie in Figur 1 beschrieben aufgebaut sein. Die Deckplatte 10 besteht hier beispielsweise aus einer Glasscheibe mit möglichst geringer Absorption, wie zum Beispiel eisenarmes Kalknatronglas. Die farbgebende Deckplatte 10 ist auf der Außenfläche 11 strukturiert (z.B. durch Ätzung, Sandstrahlen oder Walzen beim Ziehprozess) und weist auf dem strukturierten Bereich eine Beschichtung in Form einer optischen Interferenzschicht auf, was in Figur 1 und Figur 2 nicht dargestellt ist (siehe Figur 3).

In Figur 3 ist ein vergrößerter Ausschnitt der Deckplatte 10 des Solarmoduls 1 von Figur 1 und Figur 2 im Querschnitt gezeigt. Die Außenfläche 11 der Deckplatte 10 ist in einem Bereich 15 strukturiert, welcher sich im vorliegenden Beispiel über die komplette Außenfläche 11 erstreckt. Unmittelbar auf der Außenfläche 11 ist eine optische Interferenzschicht 16 angeordnet. Im strukturierten Bereich 15 ist die Außenfläche 11 mit einem Höhenprofil versehen, das Berge und Täler aufweist. Hierbei bestehen mehr als 50% der Außenfläche 11 aus ebenen Segmenten 17, deren Ebenen jeweils zur Ebene der Deckplatte 10 geneigt sind, d.h. einen von Null verschiedenen Winkel aufweisen. Die Segmente 17 haben jeweils eine Segmentfläche von mindestens 1 µm² und eine mittlere Rauigkeit von weniger als 15% der Schichtdicke d der optischen Interferenzschicht 16. Ein mittlerer Höhenunterschicht zwischen den höchsten Punkten (Berge) und niedrigsten Punkten (Täler) der Außenfläche 11 beträgt mindestens 2 µm und beispielsweise maximal 20% der Dicke der transparenten Deckplatte 10. Bezogen auf die Ebene der Deckplatte 10 haben mindestens 20% der Segmente einen Neigungswinkel im Bereich von größer als 0° bis maximal 15°, mindestens 30% der Segmente einen Neigungswinkel im Bereich von größer als 15° bis maximal 45° und weniger als 30% der Segmente 17 einen Neigungswinkel von größer als 45°. Im Ausführungsbeispiel von Figur 3 haben alle Segmente einen Neigungswinkel von maximal 45°. Die optische Interferenzschicht 16 ist dünn, mit einer Schichtdicke beispielsweise im Bereich von 0,1 bis 2 Mikrometer, so dass die Oberfläche der dünnen Interferenzschicht 16 den Bergen und Tälern des strukturierten Bereichs 15 folgt. Die optische Interferenzschicht 16 weist einen Brechungsindex n von größer als 1,7, vorzugsweise größer als 2,0 und besonders bevorzugt größer als 2,3, sowie eine möglichst geringe Absorption in Bezug auf das einfallende Licht auf. Die optische Interferenzschicht 16 kann ein- oder mehrlagig ausgebildet sein und aus einer oder mehreren Brechungsschichten bestehen. Jede Brechungsschicht weist einen bestimmten Brechungsindex auf und besteht aus demselben Material. Beispielsweise besteht die optische Interferenzschicht 16 aus MgO, SiONx, Si₃N₄, ZrO₂, TiOx und/oder SiC. Die elektrische Leitfähigkeit der einen oder mehreren Brechungsschichten sollte möglichst gering sein.

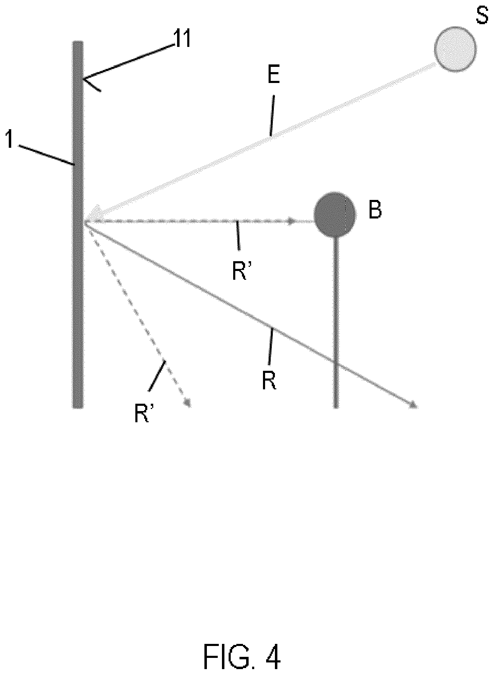

Im Weiteren wird die Funktionsweise der Strukturierung der Außenfläche 11 näher beschrieben. Sei zunächst Figur 4 betrachtet, worin beispielhaft typische Lichtverhältnisse bei einem als Fassadenelement ausgebildeten Solarmodul 1 veranschaulicht sind. Demnach trifft Licht von der Sonne S direkt auf die Außenfläche 11 des Solarmoduls 1 und wird im Glanzwinkel (Einfallswinkel = Ausfallswinkel, bezogen auf Oberflächennormale der Ebene der Deckplatte) reflektiert. Der einfallende Lichtstrahl E und der im Glanzwinkel reflektierte Lichtstrahl R sind gezeigt. Neben dem reflektierten Lichtstrahl R wird das einfallende Licht auch außerhalb des Glanzwinkels diffus gestreut. Zwei diffus gestreute Lichtstrahlen R' sind beispielhaft gezeigt. Der Farbeffekt entsteht durch Reflexion, Streuung und Interferenz. Steht ein Beobachter B vor dem Solarmodul 1 und blickt senkrecht auf die Außenfläche 11 direkt vor ihm, trifft sein Auge bei direktem Sonnenlicht nur in den seltensten Fällen das direkt reflektierte Licht R (d.h. der Beobachter steht meist nicht im Glanzwinkel). Dies ist in Figur 4 veranschaulicht, wo sich der Beobachter B außerhalb des Glanzwinkels befindet und nur den diffus gestreuten Lichtstrahl R' sieht. Bei einer glatten Oberfläche ohne strukturierten Bereich 15 ist die Intensität des diffus gestreuten Lichts R' gering und weist eine starke Winkelabhängigkeit auf. Erst wenn der diffus gestreute Anteil ausreichend groß ist, gibt es eine deutliche Farbe mit zufriedenstellender Intensität (Helligkeit, L-Wert).

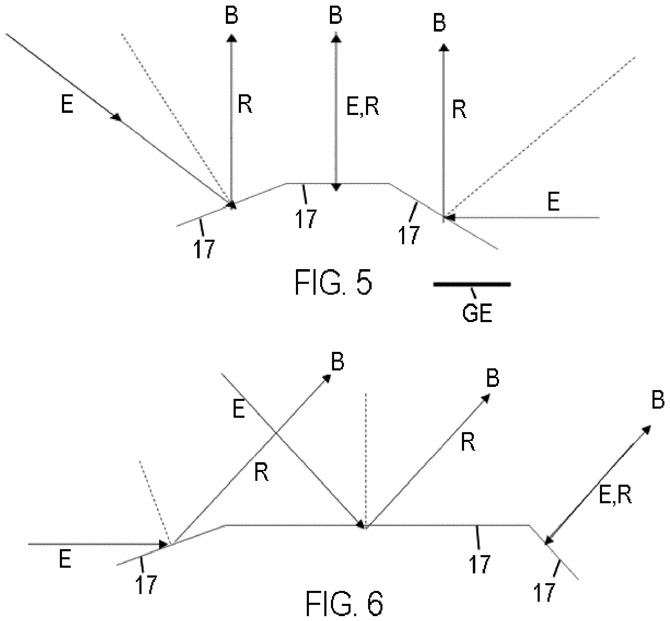

Das Grundprinzip der Wirkungsweise der geneigten Segmente 17 des strukturierten Bereichs 15 ist in Figur 5 veranschaulicht, worin beispielhaft die verschiedenen Lichtwege für einen Beobachter B gezeigt sind, der senkrecht auf die Glasoberfläche bzw. Außenfläche 11 des Solarmoduls 1 blickt. Gezeigt sind drei Segmente 17 mit verschiedenen Neigungen zur schematisch veranschaulichten Ebene GE der Deckplatte 10, sowie die auf die Segmente 17 treffenden Lichtstrahlen E, die von den Segmenten 17 jeweils im Glanzwinkel zum Beobachter B reflektiert werden (reflektierte Lichtstrahlen R). Das mittlere Segment 17 ist parallel zur Ebene GE der Deckplatte 10 angeordnet, wobei der einfallende Lichtstrahl E senkrecht auf das Segment 17 trifft und senkrecht zum Beobachter B reflektiert wird (reflektierter Strahl R). Bei den beiden angrenzenden Segmenten 17 haben die einfallenden Lichtstrahlen E jeweils einen von Null verschiedenen Winkel zur Oberflächennormalen auf die Ebene GE der Deckplatte 10 und treffen ebenfalls im Glanzwinkel auf den Beobachter B. Aufgrund der unterschiedlichen Neigungen der Segmente 17 wird Licht aus verschiedenen Richtungen jeweils im lokalen Glanzwinkel der Segmente 17 zu dem senkrecht auf die Modulfläche blickenden Beobachter B reflektiert. Im Ausführungsbeispiel von Figur 5 betragen Ein- und Ausfallswinkel maximal 45°.

In Figur 6 ist eine Situation gezeigt, bei der der Beobachter B in einem Winkel von 45° zur Oberflächennormalen auf die Ebene GE der Deckplatte 10 sieht. Wie in Figur 5 sind beispielhaft drei Segmente 17 mit verschiedenen Neigungen zur Ebene GE der Deckplatte 10 gezeigt, sowie die jeweils auf die Segmente 17 treffenden Lichtstrahlen E, die von den Segmenten 17 im lokalen Glanzwinkel zum Beobachter B reflektiert werden (reflektierte Lichtstrahlen R). Aufgrund der unterschiedlichen Neigungen der Segmente 17 wird Licht aus verschiedenen Richtungen jeweils im lokalen Glanzwinkel zu dem auf die Modulfläche blickenden Beobachter B reflektiert. Im Ausführungsbeispiel von Figur 6 betragen Ein- und Ausfallswinkel maximal 67,5°. Grundsätzlich gilt, dass bei relativ großen Werten des Glanzwinkels das reflektierte Licht blauverschoben ist. Diese Blauverschiebung kann durch einen höheren Brechungsindex der optischen Interferenzschicht reduziert werden. Bei relativ steilen Flächenneigungen kann es auch zur Mehrfach-Reflexion an benachbarten Facetten kommen.

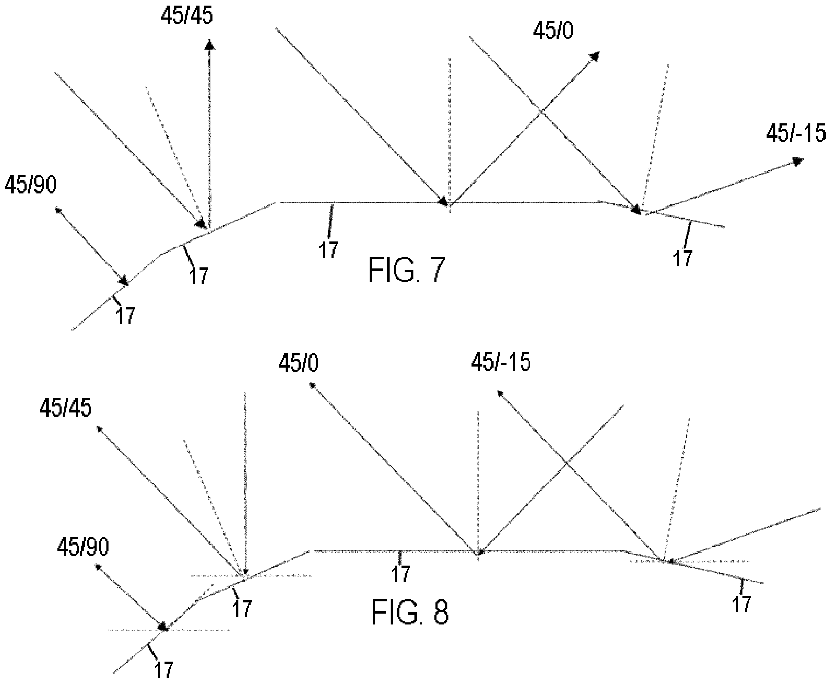

In Figur 7 ist eine Situation gezeigt, bei der die Lichtquelle und dementsprechend die einfallenden Lichtstrahlen stets in einem Winkel von 45° zur Moduloberfläche (Ebene GE der Deckplatte 10) geneigt sind. Der Beobachter B betrachtet die Moduloberfläche unter verschiedenen Winkeln. Die Winkelangaben in Figur 7 sind wie folgt zu verstehen: Einfallswinkel (bezogen auf Ebene GE der Deckplatte 10) / Beobachtungs- bzw. Reflexionswinkel (Abweichung vom Glanzwinkel bezogen auf Oberflächennormale auf Ebene GE). Das Gradzeichen "°" ist nicht angegeben. In Figur 7 sind beispielhaft vier Segmente 17 mit verschiedenen Neigungen zur Ebene GE der Deckplatte 10 gezeigt. Lediglich in einem Segment 17, dessen Ebene parallel zur Ebene GE der Deckplatte 10 ist, befindet sich der Beobachter B im Glanzwinkel in Bezug auf die Ebene GE der Deckplatte 10: 45/0. Dies bedeutet, dass der einfallende Lichtstrahl einen Winkel von 45° zur Ebene GE der Deckplatte 10 hat, der reflektierte Lichtstrahl eine Winkelabweichung Null vom Glanzwinkel. Bei den anderen Segmenten 17 befindet sich der Beobachter B außerhalb des Glanzwinkels (bezogen auf die Ebene GE der Deckplatte 10). Bei den beiden linken Segmenten 17 (45/90, 45/45), betrachtet der Beobachter die Moduloberfläche in einem Winkel von 90° bzw. 45° zum Glanzwinkel, wobei das Licht einem Winkel von 45° zur Ebene GE einfällt. Beim rechten Segment 17 (45/-15) befindet sich der Beobachter in einem Winkel von -15° zum Glanzwinkel. Aufgrund der verschieden geneigten Segmente 17 und die hierdurch bedingte lokale Reflexion im Glanzwinkel (bezogen auf die Ebene der Segmente 17) wird auch dann Licht mit hinreichender Intensität zum Beobachter B reflektiert, wenn sich der Beobachter nicht im Glanzwinkel zur Ebene GE der Deckplatte 10 befindet.

In Figur 8 ist eine Situation gezeigt, bei der der Beobachter B die Oberfläche des Solarmoduls 1 stets in einem Winkel von 45° zur Moduloberfläche bzw. Ebene GE der Deckplatte 10 beobachtet. In Figur 8 sind beispielhaft vier Segmente 17 mit verschiedenen Neigungen zur Ebene GE der Deckplatte 10 gezeigt. Lediglich in einem Segment 17, dessen Ebene parallel zur Ebene GE der Deckplatte 10 ist, befindet sich der Beobachter B im Glanzwinkel in Bezug auf die Ebene GE der Deckplatte 10: 45/0. Bei den anderen Segmenten 17 befindet sich der Beobachter B außerhalb des Glanzwinkels (bezogen auf die Ebene GE der Deckplatte 10). Bei den beiden linken Segmenten 17 (45/90, 45/45), betrachtet der Beobachter B die Moduloberfläche in einem Winkel von 45°, wobei das Licht in einer Abweichung von 90° bzw. 45° relativ zum Glanzwinkel (bezogen auf die Oberflächennormale zur Ebene GE der Deckplatte 10) einfällt. Beim rechten Segment 17 (45/-15) fällt das Licht in einem Winkel von -15° zum Glanzwinkel ein. Aufgrund der verschieden geneigten Segmente 17 und der hierdurch bedingten lokalen Reflexion im Glanzwinkel (bezogen auf die Ebene der Segmente 17) wird auch dann Licht mit hinreichender Intensität zum Beobachter B reflektiert, wenn Licht außerhalb des Glanzwinkels (bezogen auf die Ebene GE der Deckplatte 10) einfällt.

In dem erfindungsgemäßen Solarmodul 1 kann durch die Strukturierung der Außenfläche 11 der Deckplatte 10 in Kombination mit der farbgebenden optischen Interferenzschicht 16 ein homogener Farbeindruck in einem vorgebbaren Wellenlängenbereich erreicht werden, wobei der Farbeindruck im Vergleich zu einer nichtstrukturierten Moduloberfläche weitaus weniger winkelabhängig ist.

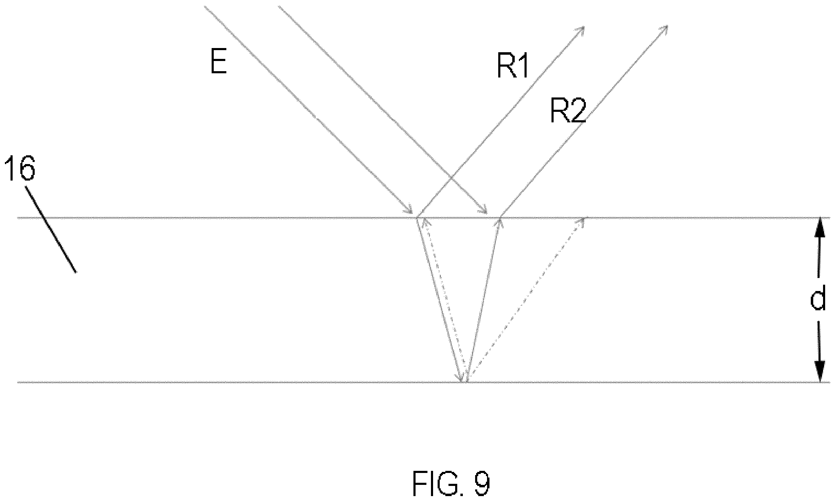

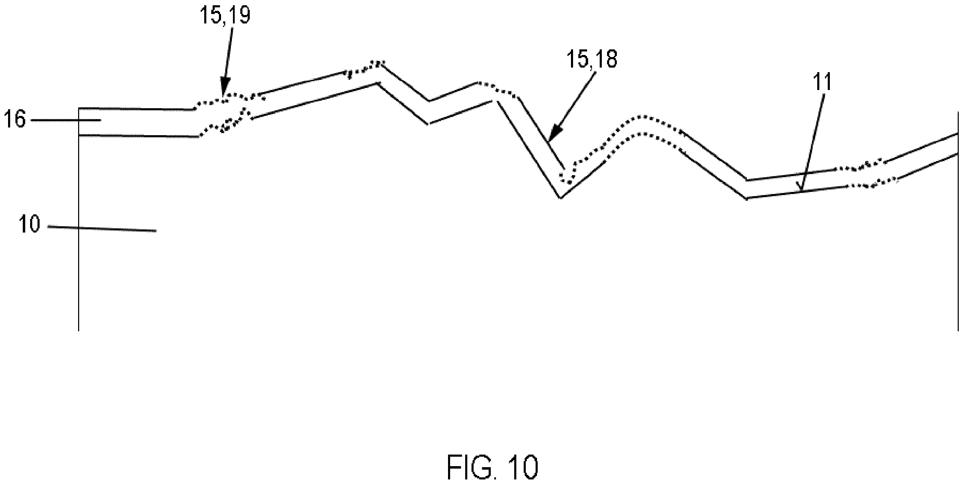

In Figur 9 ist die optische Interferenzschicht 16 mit der Schichtdicke d gezeigt. Der einfallende Lichtstrahl E wird sowohl an der Grenzfläche Atmosphäre-Interferenzschicht (R1) als auch an der Grenzfläche Interferenzschicht-Deckplatte (R2) reflektiert. Falls der Gangunterschied der beiden Lichtstrahlen R1, R2 einem Vielfachen der Wellenlänge des einfallenden Lichtstrahls entspricht, tritt konstruktive Interferenz auf, bei einem Gangunterschied von einem Vielfachen der halben Wellenlänge destruktive Interferenz. Bei Beleuchtung mit weißem Licht wirkt die optische Interferenzschicht als Farbfilter, da konstruktive Interferenz, abhängig vom Brechungsindex n und der Schichtdicke d, gemäß der Interferenzbedingung λ= 4d(n²-sin²(α))^{1/2}, nur für Licht geeigneter Wellenlänge auftritt. Hierbei ist α der Winkel der reflektierten Strahlen R1, R2, zur Oberflächennormalen. Die Lichtstrahlen R' veranschaulichten beispielhaft das reflektierte Licht außerhalb des Glanzwinkels, welche im strukturierten Bereichs 15 auftreten können, wenn die Rauigkeit der Grenzfläche zwischen Interferenzschicht-Deckplatte zu groß ist. Um die Interferenzbedingung zu erfüllen, ist es erforderlich, dass die Streuzentren jeweils kleiner als Wellenlänge und Schichtdicke sind. Dies kann durch die erfindungsgemäß beanspruchte Minimalfläche der Segmente und deren maximale Rauigkeit erreicht werden. Dieser Effekt wird gemäß einer Ausgestaltung der Erfindung ausgenutzt (siehe Figur 10).

Durch die Beschichtung der Außenfläche 11 der Deckplatte 10 mit einer optischen Interferenzschicht, bestehend aus einer anorganischen, chemisch inerten und harten Schicht wie zum Beispiel mit Si₃N₄, ergibt sich eine hohe Kratzfestigkeit, chemische Beständigkeit und schmutzabweisende Wirkung für das Solarmodul 1. Klimatests haben auch ergeben, dass die Interferenzschichten aus Materialen wie Si₃N₄ oder TiO₂ auch die Korrosion des Glases durch feuchte Hitze unterbindet. Durch die Verwendung von fotokatalytischen Schichten wie TiO₂ kann sich zudem ein selbstreinigender Effekt ergeben.

Es wird nun Bezug auf Figur 10 genommen, worin eine weitere Ausgestaltung des erfindungsgemäßen Solarmoduls 1 gezeigt ist. Um unnötige Wiederholungen zu vermeiden, werden lediglich die Unterschiede zur Ausgestaltung der Figuren 1 und 2 beschrieben und ansonsten wird auf obige Ausführungen Bezug genommen. Bei dieser Ausgestaltung weist der strukturierte Bereich 15 der Außenfläche 11 erste Zonen 18 und zweite Zonen 19 auf. Hierbei sind die ersten Zonen 18 so ausgebildet, dass die Segmente eine mittlere Rauigkeit haben, die weniger als 15% der Schichtdicke d der optischen Interferenzschicht 16 beträgt. In der Ausgestaltung von Figur 2 gilt dies für den gesamten strukturierten Bereich 15. Im Unterschied hierzu ist die mittlere Rauigkeit in den zweiten Zonen 19 so groß, dass eine Interferenz in der optischen Interferenzschicht 16 unterbunden wird. Beispielsweise beträgt die mittlere Rauigkeit der Segmente 17 in den zweiten Zonen 19 mehr als 50% der Schichtdicke der optischen Interferenzschicht 16. Das Solarmodul 1 hat deshalb in den ersten Zonen 18 eine homogene Farbe, welche sich aus der Farbfilterwirkung der optischen Interferenzschicht 16 ergibt. In den zweiten Zonen 19 hat die optische Interferenzschicht 16 durch fehlende konstruktive Interferenz keinen Farbfiltereffekt und somit liegt im Wesentlichen eine Oberfläche vor, die dem Solarmodul ohne optischer Interferenzschicht 16 entspricht. Das Solarmodul 1 kann somit wahlfrei in den vorgebbaren ersten Zonen 18 mit einer homogenen Farbe versehen werden. In Figur 10 sind die zweiten Zonen 19 durch eine größere Rauigkeit schematisch veranschaulicht.

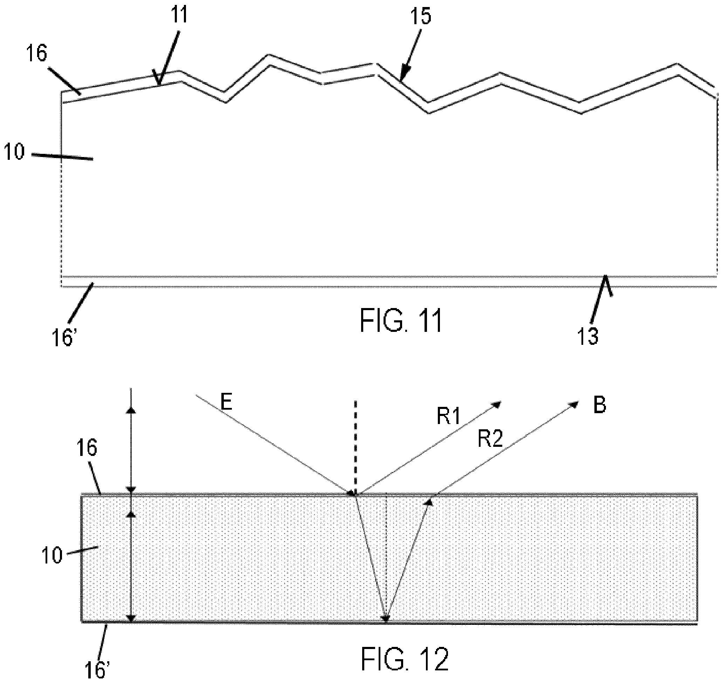

In Figur 11 ist eine weitere Ausgestaltung des erfindungsgemäßen Solarmoduls 1 veranschaulicht. Um unnötige Wiederholungen zu vermeiden, werden lediglich die Unterschiede zur Ausgestaltung der Figuren 1 und 2 beschrieben und ansonsten wird auf obige Ausführungen Bezug genommen. Demnach weist das Solarmodul 1 auf der Außenfläche 11 der Deckplatte 10 auf dem strukturierten Bereich 15 eine erste optische Interferenzschicht 16 sowie auf der Innenfläche 13 der Deckplatte 10 eine zweite optische Interferenzschicht 16' auf. Die Innenfläche 13 der Deckplatte 10 ist nicht strukturiert, d.h. weist keinen strukturierten Bereich 15 analog zur Außenfläche 11 auf. Die zweite optische Interferenzschicht 16' hat eine Schichtdicke d' und einen optischen Brechungsindex n', die gleich zu jenen der ersten optischen Interferenzschicht 16, jedoch müssen Schichtdicke und Brechungsindex nicht notwendigerweise gleich sein. Durch die zweite optische Interferenzschicht 16' wird die Farbwirkung noch verstärkt. Es gibt hierdurch eine zweite Reflexionsquelle mit Farbfilterwirkung, da der Brechungsindex der zweiten optischen Interferenzschicht zwischen der Deckplatte 10 (Glas) und der Klebeschicht 9 größer ist als jener von Deckplatte 10 (Glas) und Klebeschicht 9. Durch die Lichtbrechung ist der Eintrittswinkel bei der zweiten Reflexion geringer. Da das Licht in Summe dreimal eine optische Interferenzschicht passiert, ist das Licht, das den Beobachter erreicht, stärker gefiltert. Insbesondere können die Schichtdicken d, d' und die Brechungsindizes n, n' der beiden optischen Interferenzschichten 16, 16' auch voneinander deutlich verschieden sein. Bei Beschichtung mit deutlich unterschiedlichen optischen Dicken n*d bzw. n'* d' können Mischfarben generiert werden, da die erste optischen Interferenzschicht 16 dann ein anderes Reflexionsspektrum erzeugt als die zweite Interferenzschicht 16' und sich das reflektierte Licht von 16' bei erneutem Passieren der ersten optischen Interferenzschicht 16 überlagert. So können auf sehr einfache und kostengünstige Weise farbige Module mit einer Vielfalt von Farben und hoher Winkelstabilität erzeugt werden.

In Figur 12 ist der Strahlengang des einfallenden Lichts E und reflektierten Lichts R1, R2 bei Vorliegen von zwei optischen Interferenzschichten 16, 16' stark vereinfacht veranschaulicht. Die Figur zeigt nicht die Strukturierung der Deckplatte. Dargestellt ist nur ein einziger Strahlengang, hier im Glanzwinkel bezogen auf die Ebene der Deckplatte. Man erkennt, dass das Licht, das die erste Interferenzschicht 16 passiert hat, in der Deckplatte 10 (z.B. Glas) gebrochen wird und ein zweites Mal an der zweiten Interferenzschicht 16' reflektiert wird und dabei durch Interferenz gefiltert wird. Beim Austritt aus der Deckplatte 10 passiert es ein drittes Mal eine Interferenzschicht.

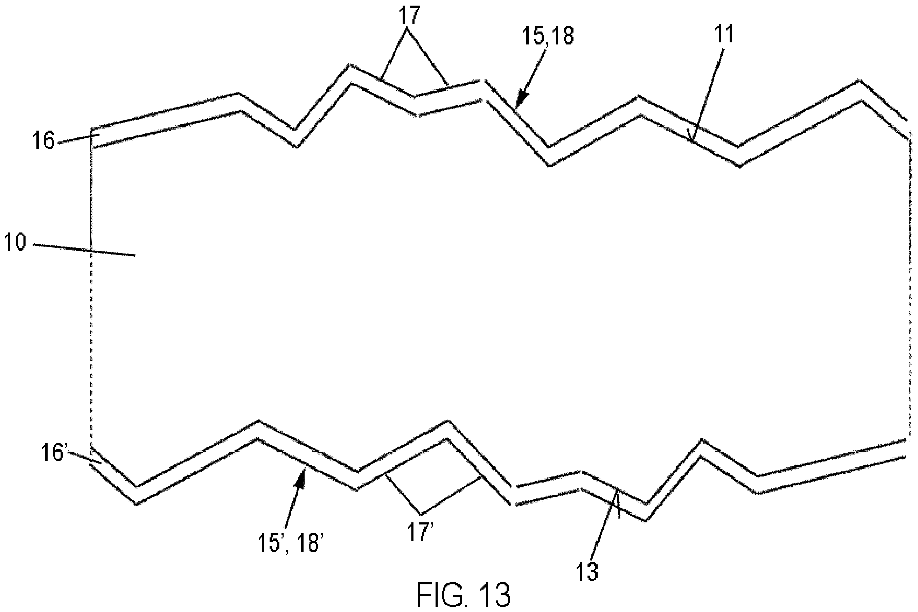

In Figur 13 ist eine weitere Ausgestaltung des erfindungsgemäßen Solarmoduls 1 veranschaulicht. Um unnötige Wiederholungen zu vermeiden, werden lediglich die Unterschiede zur Ausgestaltung von Figur 11 beschrieben und ansonsten wird auf obige Ausführungen Bezug genommen. Demnach weist das Solarmodul auf der Außenfläche 11 der Deckplatte 10 einen ersten strukturierten Bereich 15 und auf der Innenfläche 13 der Deckplatte 10 einen zweiten strukturierten Bereich 15' auf, wobei auf dem ersten strukturierten Bereich 15 eine erste optische Interferenzschicht 16 und auf dem zweiten strukturierten Bereich 15' (solarzellenseitig) eine zweite optische Interferenzschicht 16' angeordnet ist. Die beiden strukturierten Bereiche 15, 15' können analog ausgebildet sein. Ebenso können die beiden optischen Interferenzschichten 16, 16' analog ausgebildet sein und eine gleiche Schichtdicke d'= d und gleichen Brechungsindex n'= n haben, jedoch müssen Schichtdicke d' und Brechungsindex n' nicht notwendigerweise exakt gleich sein. Insbesondere können Schichtdicke d und Brechungsindex n der beiden optischen Interferenzschichten 16, 16' auch voneinander verschieden sein. Wenn eine gleiche optische Dicke n'*d' für die beiden optischen Interferenzschichten 16, 16' gewählt wird, kann die Farbe des Solarmoduls 1 verstärkt werden. Bei Beschichtung mit deutlich unterschiedlichen optischen Dicken können Mischfarben generiert werden.

Den in den Figuren 3, 11 und 12 beschriebenen Ausgestaltungen ist gemeinsam, dass bereits beim Auftreffen des Lichts auf die strukturierte Außenfläche mit Interferenzschicht durch Reflexion und Interferenz eine Farbe mit hoher Intensität und geringer Winkelabhängigkeit auch außerhalb des Glanzwinkels entsteht. Die zusätzliche Interferenzschicht und/oder Strukturierung auf der Innenfläche in den Ausgestaltungen der Figuren 11 und 12 können diese Wirkung noch verstärken.

In Figur 14 ist das Messverfahren zur Mehrwinkel-Farbmessung veranschaulicht, wobei die diffuse Streuung der noch nicht mit der optischen Interferenzschicht 16 beschichteten Deckplatte 10, die hier als Glasplatte ausgebildet ist, mit einem kommerziell verfügbaren Mehrwinkel-Farbmessgerät 21 (x-rite MA-T12) gemessen wird. Der strukturierte Bereich 15 erstreckt sich über die komplette Außenfläche 11 der Deckplatte 10. Hierbei wird ein Lichtstrahl eines D65-Normstrahlers auf die Außenfläche 11 der zu charakterisierenden Deckplatte 10 unter verschiedenen Einfallswinkeln gerichtet und das gestreute bzw. reflektierte Licht aus verschiedenen Beobachtungswinkeln, hier beispielsweise 15° oder 45° zur Oberflächennormalen der Glasebene, spektral vermessen. Unter der Deckplatte 10 befindet sich eine schwarze, nicht glänzende Schicht 20 (z.B. angebunden mit einer Flüssigkeit mit Brechungsindex bei etwa 1.5). Mit dem Mehrwinkel-Farbmessgerät 21 kann man die Helligkeit im L-a-b System bei D65 Norm Beleuchtung und 10° Öffnungswinkel bestimmen. Es hat sich gezeigt, dass eine gute Winkelstabilität (geringe Winkelabhängigkeit des gestreuten Lichts) gegeben ist, wenn sowohl bei 45° als auch bei 15° Beobachtungswinkel (jeweils bezogen auf die Normale der Ebene der Deckplatte) und bei einem Einfallswinkel von 45°, gemessen vom Glanzwinkel (in beiden Richtungen), noch mindestens eine Helligkeit von L=10, bevorzugt L=15 und noch besser L= 20 vorliegt. Die Gradangaben sind folgendermaßen zu verstehen: Reflexionswinkel (bezogen auf Oberflächennormale / Einfallswinkel (bezogen auf Glanzwinkel). Beispielsweise fällt bei einem Beobachtungswinkel von 45° (gemessen relativ zur Oberflächennormalen) und einem Einfallswinkel von 45° (gemessen vom Glanzwinkel) der einfallende Stahl genau senkrecht zur Oberfläche ein (45/45). Bei einem Beobachtungswinkel von 15° und einem Einfallswinkel von 45° liegt die Einfallsrichtung 30° von der Oberflächennormalen auf der gleichen Seite wie die Beobachtungsrichtung (15/45). Das Mehrwinkel-Farb-Messgerät 21 ist bei einem Beobachtungswinkel von 45° bzw. 15° relativ zur Oberflächennormalen positioniert.

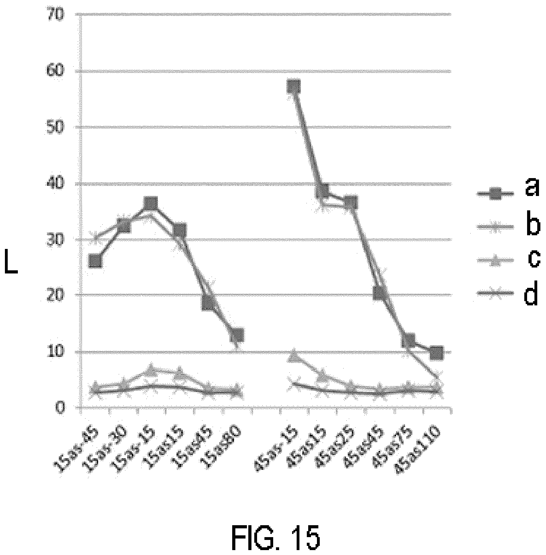

Figur 15 zeigt eine Messung der Helligkeit L mit vier verschiedenen Frontgläsern ohne farbgebende optische Interferenzschicht, gemessen mit einem Mehrwinkel-Farbmessgerät 21 wie in Figur 14. Auf der Rückseite der Frontgläser wurde mit Hilfe einer dünnen Schicht Glyzerin (Brechungsindex n= 1,47) ein beidseitig geschwärztes mattiertes Glas optisch angebunden, so dass im Wesentlichen die Reflexion der Oberfläche gemessen wird. Gemessen wurden zwei satinierte Gläser a, b mit einem Haze von 94%, ein leicht texturiertes Solarglas mit Antireflexionsschicht c (Solarglas, Typ Albarino T) mit einem Haze von 2%, sowie ein unstrukturiertes Floatglas d mit einem Haze < 0,5%. Die Winkelangaben entsprechend jenen von Figur 14, mit Ausnahme, dass "/" ersetzt ist durch "as". Die beiden satinierten Frontgläser a, b weisen auf der Außenfläche 11 einen erfindungsgemäß strukturierten Bereich 15 auf, die beiden anderen Gläser c, d weisen keinen solchen strukturierten Bereich 15 auf.

Ersichtlich zeigen die beiden satinierten Frontgläser a, b insgesamt eine deutliche höhere Intensität des reflektierten Lichtes als das leicht texturierte Solarglas c oder das unstrukturierte Floatglas d. Das Floatglas d hat im Wesentlich nur eine Reflexion im Glanzwinkel (der Glanzwinkel selbst wird bei diesem Messgerät nicht gemessen und ist folglich nicht dargestellt). Insbesondere bei Winkeln weit abseits vom Glanzwinkel ist bei den beiden satinierten Gläsern a, b noch eine deutliche Helligkeit zu erkennen. Genau dieser Effekt wird gemäß vorliegender Erfindung vorteilhaft in Kombination mit einer farbgebenden Interferenzschicht genutzt. Durch die Rauigkeit des Glases stehen immer mikroskopische Flächen mit optimalem Neigungswinkel (lokaler Glanzwinkel, Eintrittswinkel = Austrittswinkel) zur Verfügung, so dass die Richtungsabhängigkeit der Farbe und vor allem der Helligkeit deutlich kleiner ist als bei Beschichtung auf einer unstrukturierten Glasscheibe mit geringem Haze (z.B. Floatglas d). Die erfindungsgemäß strukturierte Oberfläche muss in jedem Fall Facetten und Strukturgrößen in Ausdehnungen größer als die Wellenlänge des sichtbaren Lichtes aufweisen. Dazu eignen sich zum Beispiel geätzte Gläser. Die Strukturen können aber auch im Submillimeter- und Millimeter-Bereich sein, zum Beispiel gewalzte Gläser. Es können auch gewalzte Strukturen mit geätzten Texturen kombiniert werden. Die Strukturen können auch durch Abscheideprozesse und Strukturierung eines anderen transparenten Materials auf die Deckplatte appliziert werden. Die Strukturen sollten möglichst verschiedene Flächenneigungen mit breiten Verteilungen der Neigungswinkel haben.

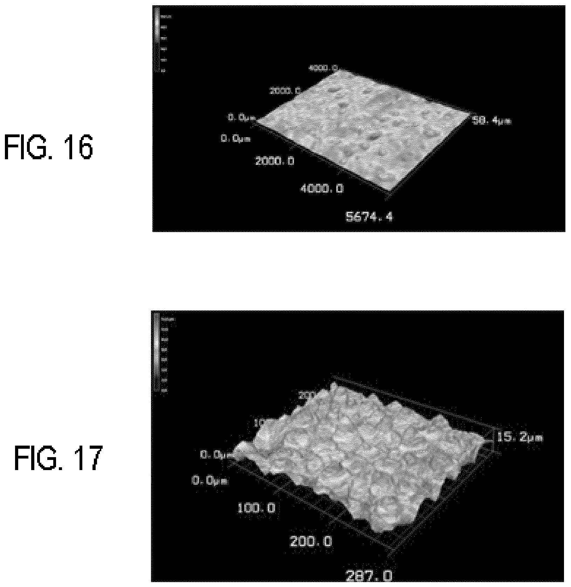

Figur 16 zeigt das Höhenprofil der leicht texturierten Glasscheibe c aus Figur 15 (Solarglas, Typ Albarino T), Figur 17 das Höhenprofil der durch Ätzung stärker strukturierten Glasscheibe a aus Figur 14 (satiniertes Glas). Die Höhenprofile wurden aus Messungen mit einem Konfokalmikroskop generiert.

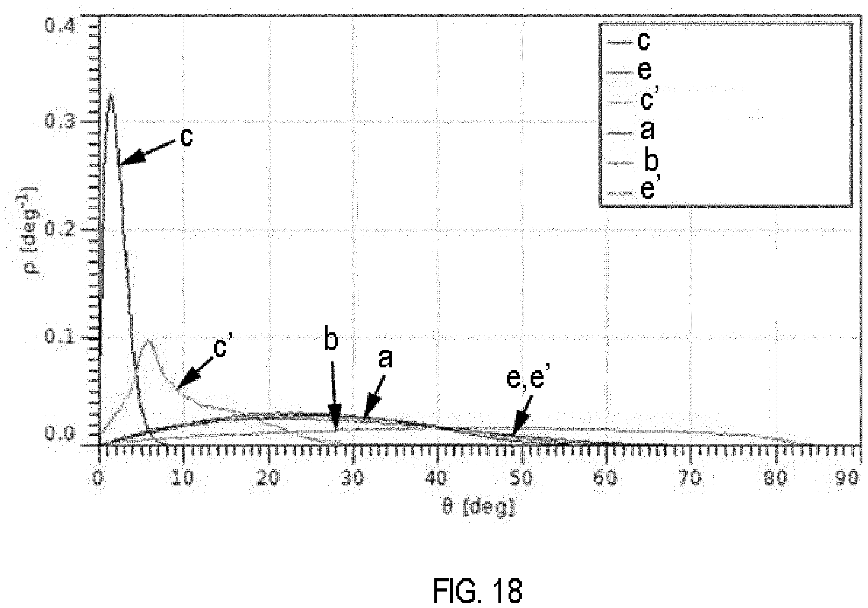

Figur 18 zeigt Winkelverteilungen, die aus den konfokalmikroskopischen Messungen von Figur 16 und 17 generiert wurden. Während bei der leicht strukturierten Glasscheibe c (Solarglas, Typ Albarino T) die Segemente sehr groß sind und Neigungswinkel von nur 5-10° auftreten, so sind die Segmente der geätzten Glasscheibe a (satiniertes Glas) im Bereich von 40 µm (Abstand Berg zu Tal in der Glasebene) mit mittleren Winkeln von ca. 25°. Die Winkelverteilung der geätzten Glasscheibe a ist sehr viel breiter als jene der leicht strukturierten Glasscheibe c. Wie auch in Figur 15 zu sehen ist, findet sich bei der leicht texturierten Glasscheibe c bei Winkeln von größer 20-30° vom Glanzwinkel nur geringe Intensität der Reflexion (gemessen als L-Wert). Hingegen sieht man bei der satinierten Glasscheibe a noch deutliche Helligkeit bei 45/45 oder 15/45. In Figur 18 sind die Winkelverteilungen weiterer Scheiben gezeigt (satinierte Glasscheibe b, leicht texturiertes Solarglas c' vom Typ Albarino S, weitere Gläser e, e').

Erfindungsgemäß kann durch Aufbringen einer optischen Interferenzschicht auf die strukturierte Oberfläche einer Glasscheibe eine deutlich erkennbare Verstärkung des Farbeffektes erreicht werden. Im Unterschied hierzu ist der Farbeffekt geringer und es liegt eine starke Winkelabhängigkeit vor, wenn eine optische Interferenzschicht auf die Innenfläche einer ansonsten unstrukturierten Glasscheibe aufgebracht wird. Zudem sind die Farben bei Beschichtung mit der optischen Interferenzschicht auf der strukturierten äußeren Seite kräftiger als bei einer Beschichtung mit der optischen Interferenzschicht auf der Innenfläche einer außen strukturierten Glasscheibe. Generell führt ein höherer Brechungsindexkontrast zu einer stärkeren Reflexion und damit zu stärkeren Farben. Durch die Beschichtung des Frontglases von außen mit der optischen Interferenzschicht (z.B. Si₃N₄) ist der Indexkontrast Luft/Si₃N₄/Glas/Verkapselungspolymer höher als bei der Schichtfolge Luft/Glas/Si₃N₄/Verkapselungspolymer. Mit SiC, ZrO₂ oder TiO₂ anstelle von Si₃N₄ ist die Farbwirkung (d.h. die Intensität des reflektierten farbigen Lichtes) noch höher.

Aus den Gesetzmäßigkeiten für die Interferenz an dünnen Schichten ergibt sich, dass die Winkelabhängigkeit der Farbänderung bei höherem Brechungsindex kleiner ist (konstruktive Interferenz für λ= 4*d*(n²-sin²(α))^{1/2}.

**Tabelle I**

| Winkel | 0 | 45 | 70 | 0 | 45 | 70 |
|---|---|---|---|---|---|---|
| Brechungsindex n | 2,0 | 2,0 | 2,0 | 2,5 | 2,5 | 2,5 |
| Dicke (nm) | 70 | 70 | 70 | 56 | 56 | 56 |
| Wellenlänge nm (1.Max) | 560 | 524 | 494 | 560 | 537 | 519 |

Aus den obigen einfachen Beispielen aus Tabelle I wird deutlich, dass sich bei schrägem Einfall eine Blauverschiebung des reflektierten Lichtes ergibt und dass diese Blauverschiebung reduziert werden kann durch einen höheren Brechungsindex.

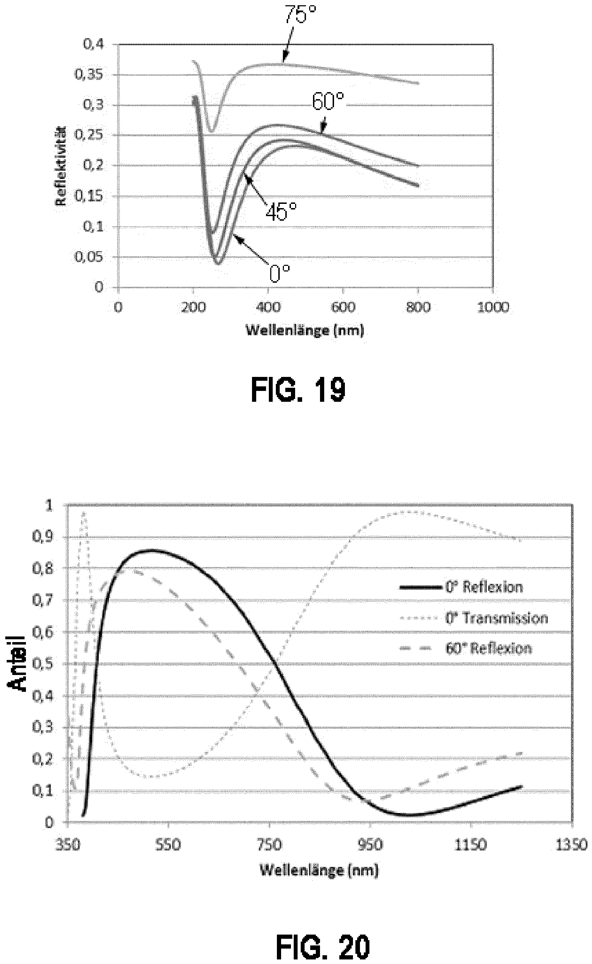

In Figur 19 ist die wellenlängenabhängige Reflektivität bei verschiedenen Winkeln dargestellt. Man erkennt wiederum die Blauverschiebung bei schrägem Einfall.

Die optische Interferenzschicht kann ein- oder mehrlagig ausgebildet sein, wobei jede Lage durch eine Brechungsschicht aus einem selben Material mit homogenem Brechungsindex gebildet wird. Insbesondere kann die optische Interferenzschicht aus genau zwei oder genau drei Brechungsschichten bestehen. Mit einer dreilagigen Schicht als Braggfilter (Lambdaviertelschichten) wird beispielsweise die Breite der farbgebenden Maxima im Reflexionsspektrum kleiner und die Intensität wird stärker. Bei geeigneter Schichtkombination kann man auch Rottöne erzeugen, die bei Einfach-Schichten kaum möglich sind, da die höheren Ordnungen immer zu viel Blau- oder Grün-Anteil einbringen. Simulationen zeigen, dass zum Beispiel mit einer Schichtkombination 65nm TiO₂/ 115nm SiO₂/ 65nm TiO₂ auf Glas ein Reflexionsspektrum mit starkem Rotanteil erhalten wird (RGB-Koordinaten (0,81; 0,31; 0,08)). Durch zwei- und dreilagige optische Interferenzschichten lässt sich auch ein besserer Kompromiss aus Transmission und Reflexion erreichen. Auch ein farbiges Solarmodul soll möglichst hohe Effizienz aufweisen. Das Maximum der Sonnenstrahlung liegt im grünen Spektralbereich. Durch zweilagige und dreilagige Schichten lässt sich der Spektralbereich des reflektierten Lichtes einengen und man hat mehr Freiheitsgrade, um den richtigen Farbton zu treffen.

Die folgende Tabelle II zeigt beispielsweise einige Schichtkombinationen und deren Eigenschaften. Hier wurde durch Simulation eine Schichtkombination gesucht, die einen bestimmten kräftigen dunkleren Blauton (L=37, a=22, b=-60) am besten trifft. Für alle Schichtsysteme wurde der Farbabstand dE von diesem Farbwert berechnet. Außerdem wurde das resultierende Transmissionsspektrum mit dem Sonnenspektrum gewichtet und die Transmission berechnet. Dann wurde daraus der Transmissionsverlust durch das Schichtsystem berechnet. Wesentlich für die Erfindung ist die Winkelstabilität der optischen Interferenzschicht. Durch Kombination einer Mehrfach-Interferenzschicht mit einer strukturierten Glasscheibe kann eine hohe Winkelstabilität und eine hohe Farbkraft des beschichteten Glaselements erreicht werden. Daher wurde für die simulierten Schichtpakete (auf glattem Substrat) auch die Differenz im Farbwert zwischen 20° und 50° Einstrahlung berechnet. Die Simulationen auf glattem Glas dienen als Anhaltspunkte für die Beschichtung auf strukturiertem Glas. Bei strukturiertem Glas sieht der Betrachter dann die Summe der Reflexionen aus unterschiedlichen Winkeln. Wenn ein Schichtpaket auf glattem Glas winkelstabiler und farbstärker ist, dann trifft das auch auf das strukturierte Glas zu. Die Winkelstabilität von Helligkeit und Sättigung ist auf strukturiertem Glas jedoch weitaus besser.

**Tabelle II**

| Schichtpaket | Transmissions-Verlust (%) | dE 20°-50° | dE zu Target |
|---|---|---|---|
| Si₃N₄ 149nm / Glas | 9 | 9 | 34 |
| TiO₂ 15nm / Glas | 7 | 2 | 51 |
| TiO₂ 115nm / Glas | 21 | 9 | 11 |
| SiO₂ 16nm / TiO₂ 111 nm | 20 | 10 | 11 |
| /Glas | | | |
| Si₃N₄ 95nm / TiO₂ 36nm /Glas | 12 | 15 | 11 |
| SiO₂ 138nm / TiO₂ 24nm /Glas | 4 | 14 | 19 |
| TiO₂ 32nm / Si₃N₄ 67nm /TiO₂ 21 nm /Glas | 15 | 12 | 7 |
| TiO₂ 23nm / Si₃N₄ 75nm / TiO₂ 22nm / Glas | 9 | 13 | 8 |

Durch dreilagige Schichten lassen sich auch nahezu weiße Solarmodule herstellen, die dennoch elektrische Leistung zeigen, da die Transmission in Richtung Solarzellen im Sichtbaren noch 10-20% und im nahen Infrarot noch über 90% beträgt.

Figur 20 zeigt simulierte Spektren eines Schichtsystems, bestehend aus 45nm TiO₂ / 90nm Si₃N₄ /45nm TiO₂. Die Farbkoeffizienten des Reflexionsspektrums dieses Schichtpaketes lässt sich in RGB Koordinaten zu (0,8; 0,86; 0,76) berechnen. Dies entspricht einem leicht grau getönten Weiss. Bei schrägem Einfall (60°) erhöht sich der Blauanteil etwas. Der Gesamteindruck bleibt jedoch relativ farbneutral bei RGB = (0,66; 0,81; 0,84).

Schon allein durch Verwendung von 2-lagigen optischen Interferenzschichten lassen sich also Helligkeit und Sättigung des Farbtons verbessern und gleichzeitig die Transmission optimieren. Vorzugsweise besteht die optische Interferenzschicht aus genau zwei Lagen aus zwei verschiedenen Materialen mit unterschiedlichem Brechungsindex n1, n2. Für die Beträge der Differenzen der Brechungsindizes gilt: |n1-nd| >0,3 und |n2-n1| >0,3 und mindestens einer der Brechungsindizes n1 oder n2 ist größer als 1,9, bevorzugt größer als 2,3 wobei n_{d} der Brechungsindex der Deckplatte ist.

Die Verwendung von 3-lagigen optischen Interferenzschichten erlaubt noch mehr Farben und eine weitere Optimierung aus Farbton, Winkelabhängigkeit und Transmission. Eine optische Interferenzschicht aus genau drei Lagen (Brechungsschichten) kann aus zwei oder drei verschiedenen Materialen mit Brechungsindizes n1, n2, n3 bestehen, wobei gilt: |n3-n2| > 0,3 und |n2-n1| > 0,3 und |n1-nd| > 0,3. Dabei verhalten sich die Werte der Brechungsindizes alternierend; also entweder n1 > n2 und n3 > n2 oder n1 < n2 und n3 < n2. Zudem ist mindestens einer der Brechungsindizes n1, n2 oder n3 größer als 1,9, bevorzugt größer als 2,3. Mögliche Materialien für die niedrigeren Brechungsindizes sind zum Beispiel SiO₂, SiON, Al₂O₃ und MgF₂. Die Kombination mit einer strukturierten Deckplatte ermöglicht schon hohe Werte für Helligkeit und Sättigung bei 1, oder 2 oder maximal 3 Lagen.

Im Folgenden werden Ergebnisse der technischen Realisierung der Erfindung in verschiedenen Ausführungsformen beschrieben:
Es wurden CIGS-Dünnschichtmodule hergestellt. Anstelle eines gewöhnlichen Frontglases wurden beschichtete und strukturierte Frontgläser verwendet. Standard-Frontgläser haben eine Antireflexschicht und sind nur leicht strukturiert (Haze =2%). Als strukturierte bzw. texturierte Gläser wurden chemisch geätzte, d.h. satinierte Gläser verwendet. Die Gläser zeigten einen Haze von 94%. Mikroskop-Analysen zeigten Oberflächenstrukturen mit einer Strukturgröße von 20-40 µm und Strukturhöhen von 15 µm. Figur 17 zeigt die Konfokalmikroskop-Aufnahme der Oberfläche der verwendeten satinierten Gläser. Die Winkel der Oberflächenstrukturen (Winkel zur Glasebene) waren eher flach mit typischen Winkeln um 20-40°. Zum Vergleich wurde ein kommerziell erhältliches Frontglas mit einer Vielfachinterferenzschicht auf der Innenseite verwendet.

Die Gläser wurden auf der strukturierten Seite mit einer Einfachschicht von Siliziumnitrid (Si₃N₄) mittels Magnetronsputtern beschichtet. Dann wurden sie mit der beschichteten und strukturierten Seite nach außen (also der Sonne zugewandten Seite) mit dem CIGS-Dünnschicht Circuit laminiert. In einem zweiten Experiment wurde auch die glatte Innenseite noch zusätzlich mit einer Siliziumnitridschicht beschichtet. Als Referenz wurde ein kommerziell erhältliches Frontglas verwendet, das innen mit einer Vielfachschicht aus verschiedenen Materialien mit unterschiedlichen Brechungsindizes beschichtet ist.

Anschließend wurden die Module mit einem Mehrwinkel-Farbmessgerät charakterisiert und die Farbwerte in Lhc-Koordinaten ausgewertet (L= Helligkeit, C= Chromazität oder Sättigung und H= Hue oder Farbton). Das MehrwinkelFarbmessgerät bietet zwei Beobachtungswinkel und jeweils 6 Beleuchtungswinkel. Die Beleuchtungswinkel werden auf den Glanzwinkel bezogen. In den Glanzwinkeln wird jeweils nicht gemessen.

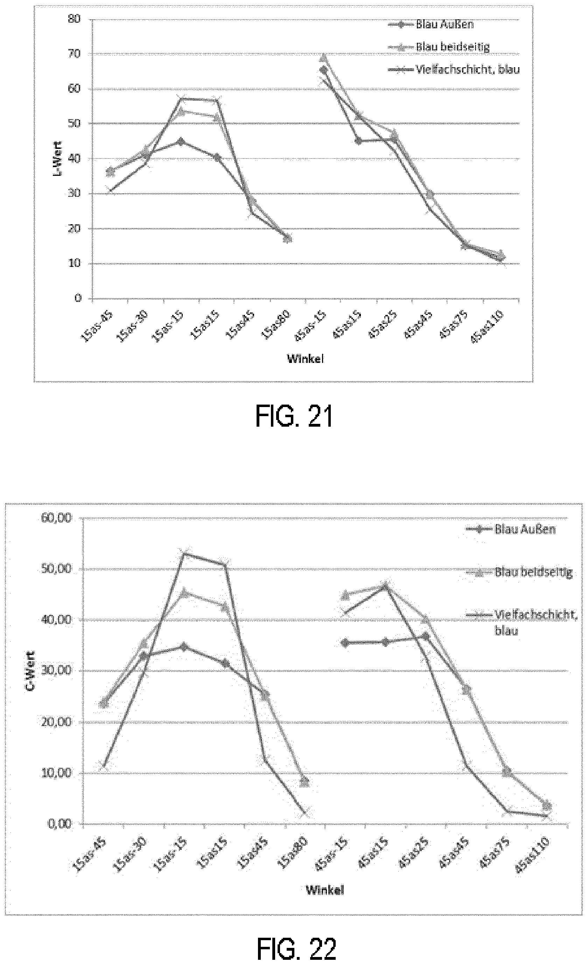

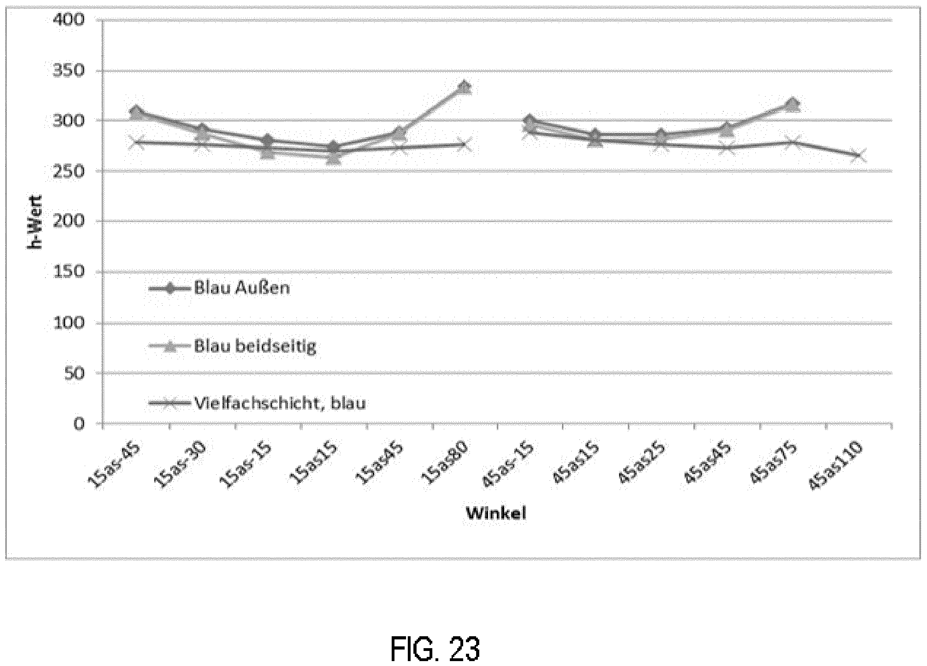

Die Figuren 21 bis 23 zeigen die Ergebnisse für L, h und c für Beschichtung außen, beidseitig und mit dem Vielfachschichtsystem (innen). Die Achsenbezeichnung "15as45" bezeichnet, analog zur bisherigen Notation, einen Detektionswinkel von 15° und einen Beleuchtungswinkel von 45° vom Glanzwinkel in Richtung Beobachtungsrichtung, d.h. der Winkel zwischen Beleuchtungs- und Beobachtungsrichtung ist kleiner als der Glanzwinkel; "15as-45" bedeutet 45° hinter dem Glanzwinkel, d.h. der Winkel zwischen Beleuchtungs- und Beobachtungsrichtung ist größer als der Glanzwinkel.

Man erkennt, dass die Helligkeit L für die Beschichtung außen zwar etwas niedriger, aber stabiler ist. Die Helligkeit L der beidseitigen Beschichtung kommt gut an die der Vielfachschicht heran. Auch in der Farbsättigung gibt sich ein ähnliches Bild: die Sättigung bei Beschichtung außen ist etwas schwächer, aber sehr stabil. Die Winkelabhängigkeit des Farbtons ist noch etwas stärker bei den erfindungsgemäßen Beschichtungen. Bei größeren Winkeln sieht man eine leichte Blauverschiebung. Das lässt sich durch Verwendung eines Materials mit höherem Brechungsindex (TiOx, SiC) reduzieren.

In einem weiteren Experiment wurden Einfach-Schichten von Si₃N₄ oder Titandioxid auf verschiedene Gläser beschichtet, und die Gläser wurden in verschiedenen Konfigurationen zu Modulen verbaut. Die Module wurden mit einem Farbmessgerät vermessen, das die Oberfläche diffus beleuchtet (Lichttyp D65) und in einem Winkel von 8° zur Oberflächennormalen die Farbe misst. Dabei kann die Beleuchtung im Glanzwinkel eingeschlossen (SCI) oder ausgeschlossen (SCE) werden. Die Farbwerte wurden in Lab Koordinaten berechnet und daraus auch Chromazität (Sättigung) und Farbton bestimmt.

**Tabelle III**

| Farbe | Material | Schichtdicke | Position | L | c | h |
|---|---|---|---|---|---|---|
| grau | Si3N4 | 26 | außen | 36 | 7 | N/A |
| blau | Si3N4 | 161 | außen | 33 | 25 | 284 |
| blau /violett | TiO2 | 125 | außen | 40 | 37 | 294 |
| grün | TiO2 | 230 | außen | 40 | 32 | 170 |
| gold | Si3N4 | 236 | außen | 50 | 22 | 108 |
| gold | TiO2 | 80 | außen | 60 | 26 | 90 |

Tabelle III zeigt, dass schon mit einlagigen Schichten gesättigte Farben und helle Farbtöne erreicht werden. Die Schichtdicken lagen im Bereich von 20nm-300nm. Mit Titandioxid konnten erwartungsgemäß noch hellere und stärker gesättigte Farbtöne hergestellt werden. Mit sehr dünnen Schichten lassen sich auch Grautöne erzeugen.

Weiterhin wurde der Unterschied zwischen der Farbe bei Einschluss vom Glanzwinkel und bei Ausschluss vom Glanzwinkel in der Farbdifferenzkennziffer dE(2000) ermittelt. Auch dieses Messverfahren gibt eine Bewertung der Winkelstabilität.

Die Ergebnisse am Beispiel der blauen Farbtöne sind in Tabelle IV unten aufgeführt. Es ergibt sich bereits ein sehr geringer dE(2000)-Wert für eine einfache Schicht aus Si₃N₄ auf einseitig satiniertem Glas. Ergänzt man diese Konfiguration mit einer weiteren Schicht Si₃N₄ innen, so erhöhen sich die Helligkeit und die Farbsättigung bei nur geringfügigem Anstieg von dE. Nimmt man TiO₂ und beschichtet dieses außen auf das einseitig satinierte Glas, so erhöht sich im Vergleich zu den vorherigen Konfigurationen die Helligkeit und die Farbsättigung bei äußerst geringem dE. Als Referenz wurde TiO₂ auf die glatte Seite einer einseitig satinierten Scheibe beschichtet und mit der Beschichtung nach außen zu einem Modul laminiert. Da Glas und Laminationsfolie sich nur geringfügig im Brechungsindex unterscheiden, hat die satinierte Seite nun kaum einen Einfluss. In diesem Fall erhält man zwar bei Einschluss des Glanzes eine gute Helligkeit und Sättigung, bei Glanzausschluß verschwindet jedoch die Farbwirkung völlig mit stark reduzierter Helligkeit und Sättigung, d.h. dE von SCI versus SCE ist sehr groß.

Zum Nachweis der Optimierung von Farbe und Leistung bei geliechbleibender Winkelstabilität wurde eine dreilageige Schicht TiO2 (27nm)/Si3N4(100nm)/TiO2(18nm) auf eine satiniertes Deckglas mit den beschriebene Struktureigenschaften beschichtet. Im Vergleich dazu wurde eine Einfachschicht TiO2 (125nm) auf ein weiteres Deckglas abgeschieden. Beide Gläser wurden zu CIGS Dünnschicht Modulen weiter verarbeitet. Beide blauen Module zeigten eine Helligkeit von L=41 und eine Sättigung von c=36; der Leistungsverlust des Modules mit der einlagigen Schicht lag bei 25%, während das Modul mit der dreilagigen Schicht nur 15% Leistung verloren hatte.

Eine bevorzugte Ausführungsform dieser Erfindung ist die Beschichtung eines Materials mit hohem Brechungsindex auf eine texturierte Glasscheibe und Einbau im Modul mit beschichteter und texturierter Seite außen. Auch die beidseitige Beschichtung ist vorteilhaft. Eine beidseitige Beschichtung auf beidseitig satiniertem Glas könnte noch einmal die Helligkeit und Sättigung erhöhen. Eine einseitige Beschichtung außen mit dreilagigen Schichten auf strukturierten Gläsern mit den oben aufgeführten Eigenschaftenführt zu fotovoltaischen Modulen für die Gebäudeintegration mit Farben hoher Sättigung, guter Winkelstabilität und optimierter Leistung.

**Tabelle IV**

| Beschreibung | Beschichtung | Konfiguration | Glanz | L* (D65) | a* (D65) | b* (D65) | c | h | dE 2000 |
|---|---|---|---|---|---|---|---|---|---|
| einseitig satiniertes Glas | Si₃N₄ | Textur außen, Beschichtung außen | SCI | 33,0 | 6,1 | -24,2 | 25,0 | 284 | 0,5 |
| einseitig satiniertes Glas | Si₃N₄ | Textur außen, Beschichtung außen | SCE | 32,6 | 6,3 | -24,0 | 24,8 | 285 | |
| einseitig satiniertes Glas | Si₃N₄ | Textur außen, Beschichtung beidseitig | SCI | 36,7 | 2,9 | -28,3 | 28,4 | 276 | 1,7 |
| einseitig satiniertes Glas | Si₃N₄ | Textur außen, Beschichtung beidseitig | SCE | 35,4 | 4,0 | -27,4 | 27,7 | 278 | |
| einseitig satiniertes Glas | TiO₂ | Textur außen, Beschichtung außen | SCI | 40,4 | 15,0 | -34,2 | 37,3 | 294 | 0,5 |
| einseitig satiniertes Glas | TiO₂ | Textur außen, Beschichtung außen | SCE | 40,1 | 15,4 | -33,9 | 37,2 | 295 | |
| einseitig satiniertes Glas | TiO₂ | Textur innen, Beschichtung außen | SCI | 41,5 | 1,4 | -43,5 | 43,6 | 272 | 35,6 |
| einseitig satiniertes Glas | TiO₂ | Textur innen, Beschichtung außen | SCE | 7,7 | 0,9 | 3,8 | 3,9 | | |
| Vielfachlagen | k.A. | Beschichtung innen | SCI | 37,0 | -0,2 | -27,9 | 27,9 | 270 | 2,1 |
| Vielfachlagen | k.A. | Beschichtung innen | SCE | 34,9 | 0,0 | -25,3 | 25,3 | 270 | |

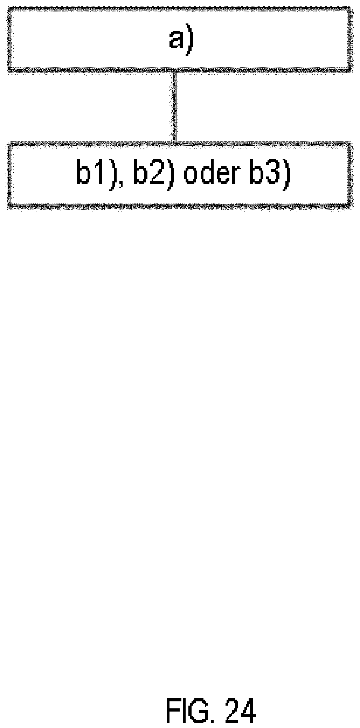

Figur 24 veranschaulicht das erfindungsgemäße Verfahren zur Herstellung des erfindungsgemäßen Solarmoduls 1, wobei lediglich die Schritte zur Bearbeitung der Deckplatte beschrieben sind.

Hierbei wird in einem ersten Verfahrensschritt a) eine ebene transparente Deckplatte bereitgestellt, die eine Außenfläche, welche der äußeren Umgebung zugewandt sein soll, und eine gegenüberliegende Innenfläche aufweist. Anschließend wird aus den folgenden drei (alternativen) Verfahrensschritten ein einziger zweiter Verfahrensschritt b1), b2) oder b3) ausgewählt und durchgeführt:
b1) Strukturieren der Außenfläche mindestens in einem Bereich und Aufbringen einer optischen Interferenzschicht auf den strukturierten Bereich. In diesem Fall wird die Innenfläche nicht strukturiert und keine optische Interferenzschicht auf die Innenfläche aufgebracht.
b2) Strukturieren der Außenfläche mindestens in einem Bereich, Aufbringen einer optischen Interferenzschicht auf den strukturierten Bereich der Außenfläche und Aufbringen einer weiteren optischen Interferenzschicht auf die Innenfläche. In diesem Fall wird die Innenfläche nicht strukturiert.
b3) Strukturieren der Außenfläche mindestens in einem Bereich, Aufbringen einer optischen Interferenzschicht auf den strukturierten Bereich der Außenfläche, Strukturieren der Innenfläche mindestens in einem Bereich und Aufbringen einer weiteren optischen Interferenzschicht auf den strukturierten Bereich der Innenfläche.

Die Erfindung stellt ein verbessertes Solarmodul sowie ein Verfahren zu dessen Herstellung zur Verfügung, das eine sehr homogene, intensive Farbe, bei geringer oder fehlender Richtungsabhängigkeit hat. Durch die Verwendung von optischer Interferenz zur Farberzeugung erhält man deutlich geringere Wirkungsgradverluste für das darunter liegende Solarmodul als bei Verwendung von opaken farbgebenden Schichten. Diese Erfindung ermöglicht ein sehr einfaches und kostengünstiges Verfahren zur Herstellung farbiger Solarmodule mit hohem Wirkungsgrad und hoher Beständigkeit.

### Bezugszeichenliste

- 1: Solarmodul
- 2: Substrat
- 3: Schichtenaufbau
- 4: Sonnenlicht
- 5: Rückelektrodenschicht
- 6: Absorberschicht
- 7: Pufferschicht
- 8: Frontelektrodenschicht
- 9: Klebeschicht
- 10: Deckplatte
- 11: Außenfläche
- 12: Solarzelle
- 13: Innenfläche
- 14: Modulrückseite
- 15, 15': strukturierter Bereich
- 16, 16': optische Interferenzschicht
- 17, 17': Segment
- 18, 18': erste Zone
- 19: zweite Zone
- 20: schwarze Schicht
- 21: Mehrwinkel-Farbmessgerät

## Patentansprüche

1. Solarmodul (1) zur fotovoltaischen Energieerzeugung, welches eine transparente Deckplatte (10) mit einer der äußeren Umgebung zugewandten Außenfläche (11) und einer gegenüberliegenden Innenfläche (13) umfasst, wobei die Außenfläche (11) mindestens einen strukturierten Bereich (15) aufweist, auf dem eine optische Interferenzschicht (16) zur Reflexion von Licht innerhalb eines vorgegebenen Wellenlängenbereichs angeordnet ist, **dadurch gekennzeichnet, dass** der strukturierte Bereich (15) folgende Merkmale hat:
- senkrecht zur Ebene der Deckplatte (10) ein Berge und Täler aufweisendes Höhenprofil, wobei ein mittlerer Höhenunterschied zwischen den Bergen und Tälern mindestens 2 µm beträgt,
- mindestens 50% des strukturierten Bereichs (15) setzt sich aus Segmenten (17) zusammen, die zur Ebene der Deckplatte geneigt sind, wobei, bezogen auf die Ebene der Deckplatte, mindestens 20% der Segmente einen Neigungswinkel im Bereich von größer als 0° bis maximal 15° und mindestens 30% der Segmente einen Neigungswinkel im Bereich von größer als 15° bis maximal 45° haben, wobei
- die Segmente (17) jeweils eben sind und eine Segmentfläche von mindestens 1 µm² haben, wobei die Segmente (17) jeweils eine mittlere Rauigkeit von weniger als 15% einer Schichtdicke der optischen Interferenzschicht (16) auf der Außenfläche (11) haben.

2. Solarmodul (1) nach Anspruch 1, bei welchem die Innenfläche (13) keinen strukturierten Bereich und keine optische Interferenzschicht aufweist.

3. Solarmodul (1) nach Anspruch 1, bei welchem die Innenfläche (13) keinen strukturierten Bereich aufweist und auf der Innenfläche (13) der Deckplatte (10) eine weitere optische Interferenzschicht (16') zur Reflexion von Licht innerhalb eines vorgegebenen Wellenlängenbereichs angeordnet ist.

4. Solarmodul (1) nach Anspruch 1, bei welchem die Innenfläche (13) mindestens einen strukturierten Bereich (15') aufweist, auf dem eine optische Interferenzschicht (16') zur Reflexion von Licht innerhalb eines vorgegebenen Wellenlängenbereichs angeordnet ist.

5. Solarmodul (1) nach einem der Ansprüche 1 bis 4, bei welchem mindestens eine optische Interferenzschicht (16, 16') genau eine Brechungsschicht enthält, wobei die Brechungsschicht einen Brechungsindex n von größer als 1,7, größer als 2,0 oder größer als 2,3 hat.

6. Solarmodul (1) nach einem der Ansprüche 1 bis 5, bei welchem mindestens eine optische Interferenzschicht (16, 16') genau zwei Brechungsschichten enthält, wobei eine erste Brechungsschicht mit einem ersten Brechungsindex n1 auf der Deckplatte (10) mit einem Brechungsindex nd angeordnet ist und eine zweite Brechungsschicht mit einem zweiten Brechungsindex n2 auf der ersten Brechungsschicht angeordnet ist, wobei für die Absolutwerte der Differenzen der Brechungsindizes gilt:|n1-nd| > 0,3 und |n2-n1| > 0,3, wobei mindestens einer der Brechungsindizes n1 oder n2 größer als 1,9, bevorzugt größer als 2,3, ist.

7. Solarmodul (1) nach einem der Ansprüche 1 bis 6, bei welchem mindestens eine optische Interferenzschicht (16, 16') genau drei Brechungsschichten enthält, wobei eine erste Brechungsschicht mit einen ersten Brechungsindex n1 auf der Deckplatte (10) mit einem Brechungsindex nd angeordnet ist eine zweite Brechungsschicht mit einem zweiten Brechungsindex n2 auf der ersten Brechungsschicht angeordnet ist und eine dritte Brechungsschicht mit einem dritten Brechungsindex n3 auf der zweiten Brechungsschicht angeordnet ist, wobei für die Absolutwerte der Differenzen der Brechungsindizes gilt: |n3-n2| > 0,3, |n2-n1| > 0,3 und |n1-nd| > 0,3, wobei mindestens einer der Brechungsindizes n1, n2 oder n3 größer als 1,9, bevorzugt größer als 2,3, ist, wobei gilt:
(i) n1 > n2 und n3 > n2, oder (ii) n1 < n2 und n3 < n2.

8. Solarmodul (1) nach einem der Ansprüche 1 bis 7, bei welchem mindestens 80% eines strukturierten Bereichs (15, 15') aus zur Ebene der Deckplatte (10) geneigten Segmenten (17, 17') zusammengesetzt ist.

9. Solarmodul (1) nach einem der Ansprüche 1 bis 8, bei welchem
i) mindestens 30% der Segmente (17, 17') einen Neigungswinkel im Bereich von größer als 0° bis maximal 15°, mindestens 40% der Segmente (17, 17') einen Neigungswinkel im Bereich von größer als 15° bis maximal 45° und weniger als 10% der Segmente (17, 17') einen Neigungswinkel von größer als 45° haben, oder
ii) mindestens 40% der Segmente (17, 17') einen Neigungswinkel im Bereich von größer als 0° bis maximal 15°, mindestens 50% der Segmente (17, 17') einen Neigungswinkel im Bereich von größer als 15° bis maximal 45° und weniger als 10% der Segmente (17, 17') einen Neigungswinkel von größer als 45° haben.

10. Solarmodul (1) nach einem der Ansprüche 1 bis 9, bei welchem mindestens eine optische Interferenzschicht (16, 16') mindestens eine Verbindung, gewählt aus TiOₓ, ZrOₓ, SiC und Si₃N₄, enthält.

11. Solarmodul (1) nach einem der Ansprüche 1 bis 4 und 6 bis 10, bei welchem mindestens eine optische Interferenzschicht (16, 16') mindestens eine Verbindung, gewählt aus MgF₂, Al₂O₃, SiO₂ und Siliziumoxinitrid, enthält.

12. Solarmodul (1) nach einem der Ansprüche 1 bis 11, bei welchem die Deckplatte (10) einen Reflexions-Haze von mehr als 50%, insbesondere mehr als 90%, aufweist.

13. Solarmodul (1) nach einem der Ansprüche 1 bis 12, bei welchem die mit einer schwarzen Rückfläche versehene, strukturierte, unbeschichtete Deckplatte (10) so ausgebildet ist, dass bei einem Beobachtungswinkel von 45° und 15° und einem Einfallswinkel, der um 45° vom jeweiligen Glanzwinkel abweicht, eine Helligkeit L des reflektierten Lichts von mindestens 10, mindestens 15 oder mindestens 20 auftritt.

14. Solarmodul (1) nach einem der Ansprüche 1 bis 13, bei welchem ein mittlerer Höhenunterschied zwischen den Bergen und Tälern mindestens 50 µm, insbesondere mindestens 100 µm, beträgt.

15. Verfahren zur Herstellung eines Solarmoduls (1) nach einem der Ansprüche 1 bis 14, welches die folgenden Schritte umfasst:
a) Bereitstellen einer transparenten Deckplatte (10) mit einer Außenfläche (11), welche einer äußeren Umgebung zugewandt sein soll, und einer gegenüberliegenden Innenfläche (13),
b1) Strukturieren der Außenfläche (11) mindestens in einem Bereich (15) und Aufbringen einer optischen Interferenzschicht (16) auf den strukturierten Bereich (15), oder
b2) Strukturieren der Außenfläche (11) mindestens in einem Bereich (15), Aufbringen einer optischen Interferenzschicht (16) auf den strukturierten Bereich (15) und Aufbringen einer weiteren optischen Interferenzschicht (16') auf die Innenfläche (13), oder
b3) Strukturieren der Außenfläche (11) mindestens in einem Bereich (15), Aufbringen einer optischen Interferenzschicht (16) auf den strukturierten Bereich (15), Strukturieren der Innenfläche (13) mindestens in einem Bereich (15') und Aufbringen einer weiteren optischen Interferenzschicht (16') auf den strukturierten Bereich (15') der Innenfläche (13),
wobei der strukturierte Bereich (15, 15') folgende Merkmale hat:
- senkrecht zur Ebene der Deckplatte (10) ein Berge und Täler aufweisendes Höhenprofil, wobei ein mittlerer Höhenunterschied zwischen den Bergen und Tälern mindestens 2 µm beträgt,
- mindestens 50% des strukturierten Bereichs (15, 15') setzt sich aus Segmenten (17, 17') zusammen, die zu einer Ebene der Deckplatte (10) geneigt sind, wobei, bezogen auf die Ebene der Deckplatte (10), mindestens 20% der Segmente (17, 17') einen Neigungswinkel im Bereich von größer als 0° bis maximal 15° und mindestens 30% der Segmente (17, 17') einen Neigungswinkel im Bereich von größer als 15° bis maximal 45° haben, wobei
- die Segmente (17, 17') jeweils eben sind und eine Segmentfläche von mindestens 1 µm² haben, wobei die Segmente (17, 17') jeweils eine mittlere Rauigkeit von weniger als 15% einer Schichtdicke der optischen Interferenzschicht (16) auf der Außenfläche (11) haben.

16. Verwendung des farbigen Solarmoduls (1) nach einem der Ansprüche 1 bis 14 als integrierter Bestandteil einer Gebäudehülle oder freistehenden Wand, insbesondere als Fenster-, Fassaden- oder Dachelement.

## Claims

1. A solar module (1) for photovoltaic energy generation, which comprises a transparent cover plate (10) with an outer surface (11) facing the external environment and an opposite inner surface (13), wherein the outer surface (11) has at least one patterned region (15), on which an optical interference layer (16) for reflecting light within a predefined wavelength range is arranged, wherein the patterned region (15) has the following features:
- perpendicular to the plane of the cover plate (10), a height profile having hills and valleys, wherein a mean height difference between the hills and valleys is at least 2 pm,
- at least 50% of the patterned region (15) is composed of segments (17) that are inclined relative to the plane of the cover plate, wherein, with reference to the plane of the cover plate, at least 20% of the segments have an inclination angle in the range from greater than 00 to a maximum of 15°, and at least 30% of the segments have an inclination angle in the range from greater than 15° to a maximum of 45°, wherein
- the segments (17) are in each case flat and have a segment area of at least 1 pm2, wherein the segments (17) have in each case a mean roughness of less than 15% of a layer thickness of the optical interference layer (16) on the outer surface (11).

2. A solar module (1) according to claim 1, wherein the inner surface (13) has no patterned region and no optical interference layer.

3. A solar module (1) according to claim 1, wherein the inner surface (13) has no patterned region and another optical interference layer (16') for reflecting light within a predefined wavelength range is arranged on the inner surface (13) of the cover plate (10).

4. A solar module (1) according to claim 1, wherein the inner surface (13) has at least one patterned region (15'), on which an optical interference layer (16') for reflecting light within a predefined wavelength range is arranged.

5. A solar module (1) according to one of claims 1 through 4, wherein at least one optical interference layer (16, 16') includes exactly one refraction layer, wherein the refraction layer has a refractive index n greater than 1.7, greater than 2.0, or greater than 2.3.

6. A solar module (1) according to one of claims 1 through 5, wherein at least one optical interference layer (16, 16') includes exactly two refraction layers, wherein a first refraction layer with a first refractive index n1 is arranged on the cover plate (10) with a refractive index nd, and a second refraction layer with a second refractive index n2 is arranged on the first refraction layer, wherein the following applies to the absolute values of the differences in the refractive indices: |n1-nd| > 0.3 and |n2-n1| > 0.3, wherein at least one of the refractive indices n1 or n2 is greater than 1.9, preferably greater than 2.3.

7. A solar module (1) according to one of claims 1 through 6, wherein at least one optical interference layer (16, 16') includes exactly three refraction layers, wherein a first refraction layer with a first refractive index n1 is arranged on the cover plate (10) with a refractive index nd, a second refraction layer with a second refractive index n2 is arranged on the first refraction layer, and a third refraction layer with a third refractive index n3 is arranged on the second refraction layer, wherein the following applies to the absolute values of the differences in the refractive indices: |n3-n2|>0.3, |n2-n1>0.3, and |n1-nd|>0.3, wherein at least one of the refractive indices n1, n2, or n3 is greater than 1.9, preferably greater than 2.3, wherein the following applies:
(i) n1>n2 and n3>n2, or (ii) n1 < n2 and n3 < n2.

8. A solar module (1) according to one of claims 1 through 7, wherein at least 80% of a patterned region (15, 15') is composed of segments (17, 17') inclined relative to the plane of the cover plate (10).

9. A solar module (1) according to one of claims 1 through 8, wherein
i) at least 30% of the segments (17, 17') have an inclination angle in the range from greater than 00 to a maximum of 15°, at least 40% of the segments (17, 17') have an inclination angle in the range from greater than 15° to a maximum of 45°, and less than 10% of the segments (17, 17') have an inclination angle greater than 45°, or
ii) at least 40% of the segments (17, 17') have an inclination angle in the range from greater than 00 to a maximum of 15°, at least 50% of the segments (17, 17') have an inclination angle in the range from greater than 15° to a maximum of 45°, and less than 10% of the segments (17, 17') have an inclination angle greater than 45°.

10. A solar module (1) according to one of claims 1 through 9, wherein at least one optical interference layer (16, 16') contains at least one compound selected from TiOx, ZrOx, SiC, and SisN4.

11. A solar module (1) according to one of claims 1 through 4 and 6 through 10, wherein at least one optical interference layer (16, 16') contains at least one compound selected from MgF2, Al203, SiO2, and silicon oxynitride.

12. A solar module (1) according to one of claims 1 through 11, wherein the cover plate (10) has reflection haze of more than 50%, in particular more than 90%.

13. A solar module (1) according to one of claims 1 through 12, wherein the patterned, uncoated cover plate (10) provided with a black back surface is implemented such that with a viewing angle of 45° and 15° and an angle of incidence that deviates by 45° from the respective glancing angle (in both directions), a brightness L of the reflected light of at least 10, at least 15, or at least 20 occurs.

14. A solar module (1) according to one of claims 1 through 13, wherein a mean height difference between the hills and valleys is at least 50 pm, in particular at least 100 pm.

15. A method for producing a solar module (1) according to one of claims 1 through 14, which comprises the following steps:
a) Providing a transparent cover plate (10) with an outer surface (11), which is intended to face an external environment, and an opposite inner surface (13),
b1) Patterning the outer surface (11) at least in one region (15), and applying an optical interference layer (16) on the patterned region (15), or
b2) Patterning the outer surface (11) at least in one region (15), applying an optical interference layer (16) on the patterned region (15), and applying another optical interference layer (16') on the inner surface (13), or
b3) Patterning the outer surface (11) at least in one region (15), applying an optical interference layer (16) on the patterned region (15), patterning the inner surface (13) at least in one region (15'), and applying another optical interference layer (16') on the patterned region (15') of the inner surface (13), wherein the patterned region (15, 15') has the following features:
- perpendicular to the plane of the cover plate (10), a height profile having hills and valleys, wherein a mean height difference between the hills and valleys is at least 2 pm,
- at least 50% of the patterned region (15, 15') is composed of segments (17, 17') that are inclined relative to a plane of the cover plate (10), wherein, with reference to the plane of the cover plate (10), at least 20% of the segments (17, 17') have an inclination angle in the range from greater than O0 to a maximum of 15°, and at least 30% of the segments (17, 17') have an inclination angle in the range from greater than 15° to a maximum of 45°, wherein
- the segments (17, 17') are in each case flat and have a segment area of at least 1 pm2, wherein the segments (17, 17') have in each case a mean roughness of less than 15% of a layer thickness of the optical interference layer (16) on the outer surface (11).

16. Use of the colored solar module (1) according to one of claims 1 through 14 as an integrated component of a building envelope or a freestanding wall, in particular as a window, facade, or roof element.

## Revendications

1. Module solaire (1) pour la génération d'énergie photovoltaïque, comprenant un couvercle transparent (10), le couvercle transparent (10) ayant une surface extérieure orientée vers l'environnement extérieur (11) et une surface intérieure opposée (13), dans lequel la surface extérieure (11) comprend au moins une zone à motifs (15) sur laquelle est disposée une couche d'interférence optique (16) pour refléter la lumière à longueur d'onde dans une plage prédéterminée, La zone à motifs (15) présentant les caractéristiques suivantes:
- un plan perpendiculaire au couvercle (10) présentant un profil de hauteur à saillie et à dépression, dans lequel la différence de hauteur moyenne entre la saillie et la dépression est d'au moins 2 µm,
- au moins 50% de la zone à motifs (15) se compose d'une section (17), la section (17) étant inclinée par rapport au plan au couvercle, dans lequel au moins 20% de la section présente un angle d'inclinaison supérieur à 0°et jusqu'à 15° au maximum par rapport au plan du couvercle, et au moins 30% de la section présente un angle d'inclinaison supérieur à 15°et jusqu'à 45° au maximum, dans lequel
- la section (17) est plate en tout cas et présente une surface de section d'au moins 1 µm², la section (17) présentant en tout cas une rugosité moyenne inférieure à 15% de l'épaisseur de la couche d'interférence optique (16) sur la surface extérieure (11).

2. Module solaire (1) selon la revendication 1, dans lequel la surface intérieure (13) ne comprend pas de zone à motifs et de couche d'interférence optique.

3. Module solaire (1) selon la revendication 1, dans lequel la surface intérieure (13) ne comprend pas de zone à motifs, et une couche d'interférence optique supplémentaire (16') pour refléter la lumière à longueur d'onde dans une plage de prédéterminée est disposée sur la surface intérieure (13) du couvercle (10).

4. Module solaire (1) selon la revendication 1, dans lequel la surface intérieure (13) comprend au moins une zone à motifs (15') sur laquelle est disposée une couche d'interférence optique (16') pour refléter la lumière à longueur d'onde dans une plage de prédéterminée.

5. Module solaire (1) selon l'une quelconque des revendications 1 à 4, dans lequel au moins une couche d'interférence optique (16, 16') comprend exactement une couche de réfraction ayant un indice de réfraction n supérieur n à 1.7, supérieur à 2.0 ou supérieur à 2.3.

6. Module solaire (1) selon l'une quelconque des revendications 1 à 5, dans lequel au moins une couche d'interférence optique (16, 16') comprend exactement deux couches de réfraction, dans lesquelles la première couche de réfraction ayant le premier indice de réfraction n1 est disposée sur une couvercle (10) ayant un indice de réfraction nd, et la deuxième couche de réfraction ayant le deuxième indice de réfraction n2 est disposée sur la première couche de réfraction, où les valeurs absolues suivantes s'appliquent à la différence de l'indice de réfraction: |n1-nd| > 0.3 et |n2-n1| > 0.3, où au moins un des indices de réfraction n1 ou n2 est supérieur à 1.9, de préférence supérieur à 2.3.

7. Module solaire (1) selon l'une quelconque des revendications 1 à 6, dans lequel au moins une couche d'interférence optique (16, 16') comprend exactement trois couches de réfraction, dans lesquelles la première couche de réfraction avec le premier indice de réfraction n1 est disposée sur une couvercle (10) avec indice de réfraction nd et la deuxième couche de réfraction avec le deuxième indice de réfraction n2 est disposée sur la première couche de réfraction, et la troisième couche de réfraction avec le troisième indice de réfraction n3 est disposée sur la deuxième couche de réfraction, où les valeurs absolues suivantes s'appliquent à la différence de l'indice de réfraction: |n3-n2| > 0.3, |n2-n1| > 0.3 et |n1-nd| > 0.3, où au moins un des indices de réfraction n1, n2 ou n3 est supérieur à 1.9, de préférence supérieur à 2.3, dont les suivantes.:
(i) n1 > n2 et n3 > n2, ou (ii) n1 < n2 et n3 < n2.

8. Module solaire (1) selon l'une quelconque des revendications 1 à 7, dans lequel au moins 80% de la zone à motifs (15, 15') se compose d'une section (17, 17') inclinée par rapport au plan de la couvercle (10).

9. Module solaire (1) selon l'une quelconque des revendications 1 à 8, dans lequel:
ii) au moins 30% de la section (17, 17') a un angle d'inclinaison supérieur à 0° jusqu'à 15°au maximum, au moins 40% de la section (17, 17') a un angle d'inclinaison supérieur à 15° jusqu'à 45°au maximum, et moins de 10% de la section (17, 17') a un angle d'inclinaison supérieur à 45°, ou
ii) au moins 40% de la section (17, 17') ont un angle d'inclinaison supérieur à 0° jusqu'à 15°au maximum, au moins 50% des sections (17, 17') ont un angle d'inclinaison supérieur à 15° jusqu'à 45°au maximum et au moins 10% de la section (17, 17') ont un angle d'inclinaison supérieur à 45°.

10. Module solaire (1) selon l'une quelconque des revendications 1 à 9, dans lequel au moins une couche d'interférence optique (16, 16') contient au moins un composé sélectionné à partir de TiOx, ZrOx, SiC et Si₃N₄.

11. Module solaire (1) selon l'une quelconque des revendications 1 à 4 et 6 à 10, dans lesquels au moins une couche d'interférence optique (16, 16') contient au moins un composé sélectionné à partir de MgF₂, Al₂O₃, SiO₂ et oxynitrure de silicium.

12. Module solaire (1) selon l'une quelconque des revendications, dans lequel le couvercle (10) a une brume réfléchissante supérieure à 50%, en particulier supérieure à 90%.

13. Module solaire (1) selon l'une quelconque des revendications 1 à 12, dans lequel un couvercle à motifs de recouvrement non revêtu (10) est réalisé avec une surface arrière noire de telle sorte que la luminosité L de la lumière réfléchie soit d'au moins 10, d'au moins 15 ou d'au moins 20 dans le cas l'angle de vue de 45° et 15° et angle d'incidence de 45° par rapport à l'angle balayé correspondant dans les deux directions.

14. Module solaire (1) selon l'une quelconque des revendications 1 à 13, dans lequel la différence de hauteur moyenne entre le renflement et la dépression est d'au moins 50 µm, en particulier d'au moins 100 µm.

15. Procédé de fabrication du module solaire (1) selon l'une quelconque des revendications 1 à 14, comprenant les étapes suivantes:
a) fournir un couvercle transparent (10) ayant une surface extérieure (11) tournée vers l'environnement extérieur et une surface intérieure opposée (13),
b1) la surface extérieure (11) est modelée dans au moins une zone (15) et une couche d'interférence optique (16) est appliquée sur la zone à motifs (15), ou
b2) la surface extérieure (11) est modelée dans au moins une zone (15), une couche d'interférence optique (16) est appliquée sur la zone à motifs (15) et une autre couche d'interférence optique (16') est appliquée sur la surface intérieure (13), ou
b3) la surface extérieure (11) est modelée dans au moins une zone (15), une couche d'interférence optique (16) est appliquée sur la zone à motifs (15), la surface intérieure (13) est modelée dans au moins une zone (15') et une autre couche d'interférence optique (16') est appliquée sur la zone à motifs (15') de la surface intérieure (13),
Dans laquelle la zone à motifs (15, 15') présente les caractéristiques suivantes:
- au moins 50% de la zone à motifs (15, 15') se compose de sections (17, 17') inclinées par rapport au plan du couvercle (10), dans lesquelles au moins 20% des sections (17, 17') ont un angle d'inclinaison supérieur à 0° jusqu'à 15°au maximum par rapport au plan du couvercle (10), et au moins 30% des sections (17, 17') ont un angle d'inclinaison supérieur à 15° jusqu'à 45° au maximum, dont:
- la section (17, 17') est plate dans chaque cas et a une surface de Section d'au moins 1µm², où la section (17, 17') a dans chaque cas une rugosité moyenne inférieure à 15% de l'épaisseur de la couche (16) de la couche d'interférence optique sur la surface extérieure (11).

16. Selon l'une quelconque des revendications 1 à 14, module solaire coloré (1) comme élément intégré d'une enveloppe de bâtiment ou d'un mur autonome, en particulier comme élément de fenêtre, de façade ou de toit.
